# EUROPEAN PATENT APPLICATION

(11) **EP 4 788 085 A1**
(43) Date of publication of application: **05.08.2026**
(21) Application number: 25195284.2
(22) Date of filing: 12.08.2025
(51) Int. Cl.: H10B 43/50, H10B 43/27, H10B 43/10

(54) **SEMICONDUCTOR DEVICE AND ELECTRONIC SYSTEM INCLUDING SEMICONDUCTOR DEVICE**

(30) Priority: 03.02.2025 KR 20250013156
(71) Applicant: Samsung Electronics Co., Ltd., Suwon-si, Gyeonggi-do 16677 (KR)
(72) Inventor: CHAE, Jiwoong, 16677 Suwon-si, Gyeonggi-do (KR); CHUNG, Soochan, 16677 Suwon-si, Gyeonggi-do (KR); KWAK, Solmi, 16677 Suwon-si, Gyeonggi-do (KR); SEON, Namho, 16677 Suwon-si, Gyeonggi-do (KR); LEE, Gilsung, 16677 Suwon-si, Gyeonggi-do (KR); JANG, Hanbyeol, 16677 Suwon-si, Gyeonggi-do (KR)
(74) Representative: Kuhnen & Wacker Patent- und Rechtsanwaltsbüro PartG mbB

(57) **Abstract**

A semiconductor device includes a gate stacking structure (120), a channel structure (CH), a cover insulation layer (168a), and a common source layer (170). The gate stacking structure (120) has a first surface (120a) and a second surface opposite to each other, and includes a plurality of interlayer insulation layers (132m) and a plurality of gate electrodes (130) alternately stacked on each other. The channel structure (CH) includes a channel penetration portion (CHa) and a channel expanded portion (CHb). The channel structure (CH) includes a channel layer (140) and a gate dielectric layer (150). The gate dielectric layer (150) includes a first dielectric portion (150a) in the channel penetration portion (CHa) and a second dielectric portion (150b) extending from the first dielectric portion (150a) in a horizontal direction at a portion adjacent to the first surface (120a) of the gate stacking structure (120).

## Description

### BACKGROUND

### (a) Field

The present disclosure relates to a semiconductor device and an electronic system including the same.

### (b) Description of the Related Art

In an electronic system implementing a data storage, a semiconductor device capable of storing high-capacity data is in demand. Accordingly, a method for increasing a data storage capacity of a semiconductor device is being researched. For example, as one method for increasing a data storage capacity of a semiconductor device, a semiconductor device including three-dimensionally arranged memory cells instead of two-dimensionally arranged memory cells has been proposed.

### SUMMARY

The present disclosure attempts to provide a semiconductor device capable of improving productivity and reliability and an electronic system including the same.

A semiconductor device according to an embodiment includes a cell array region and a connection region. The semiconductor device includes a gate stacking structure, a channel structure, a cover insulation layer, and a common source layer. The gate stacking structure has a first surface and a second surface opposite to each other, and includes a plurality of interlayer insulation layers and a plurality of gate electrodes alternately stacked on each other. The channel structure includes a channel penetration portion and a channel expanded portion. The channel penetration portion extends to pass through the gate stacking structure. The channel expanded portion is on the first surface of the gate stacking structure and has a width or an area greater than a width or an area of the channel penetration portion. The cover insulation layer is on the first surface of the gate stacking structure, and covers the connection region and has an opening exposing at least a portion of the cell array region. The common source layer includes a horizontal conductive portion. The horizontal conductive portion is on the first surface of the gate stacking structure and the channel expanded portion exposed by the opening. The channel structure includes a channel layer and a gate dielectric layer. The gate dielectric layer includes a first dielectric portion in the channel penetration portion and a second dielectric portion extending from the first dielectric portion in a horizontal direction at a portion adjacent to the first surface of the gate stacking structure.

A semiconductor device according to an embodiment includes a gate stacking structure, a channel structure, and a common source layer. The gate stacking structure has a first surface and a second surface opposite to each other, and includes a plurality of interlayer insulation layers and a plurality of gate electrodes alternately stacked on each other. The channel structure includes a channel penetration portion and a channel expanded portion. The channel penetration portion extends to pass through the gate stacking structure. The channel expanded portion is on the first surface of the gate stacking structure and has a width or an area greater than a width or an area of the channel penetration portion. The channel structure includes a channel layer and a gate dielectric layer. The gate dielectric layer includes a first dielectric portion in the channel penetration portion and a second dielectric portion extending from the first dielectric portion in a horizontal direction at a portion adjacent to the first surface of the gate stacking structure. The doped semiconductor layer includes a first extending portion and a second extending portion. The first extending portion is between the second dielectric portion and the channel expanded portion. The second extending portion extends from the first extending portion and is at a side surface of the channel penetration portion.

An electronic system according to an embodiment includes a main substrate, and a semiconductor device on the main substrate, and a controller electrically connected to the semiconductor device on the main substrate. The semiconductor device includes a cell array region and a connection region. The semiconductor device includes a gate stacking structure, a channel structure, a cover insulation layer, and a common source layer. The gate stacking structure has a first surface and a second surface opposite to each other, and includes a plurality of interlayer insulation layers and a plurality of gate electrodes alternately stacked on each other. The channel structure includes a channel penetration portion and a channel expanded portion. The channel penetration portion extends to pass through the gate stacking structure. The channel expanded portion is on the first surface of the gate stacking structure and has a width or an area greater than a width or an area of the channel penetration portion. The cover insulation layer is on the first surface of the gate stacking structure, and covers the connection region and has an opening exposing at least a portion of the cell array region. The common source layer includes a horizontal conductive portion. The horizontal conductive portion is on the first surface of the gate stacking structure and the channel expanded portion exposed by the opening. The channel structure includes a channel layer and a gate dielectric layer. The gate dielectric layer includes a first dielectric portion in the channel penetration portion and a second dielectric portion extending from the first dielectric portion in a horizontal direction at a portion adjacent to the first surface of the gate stacking structure.

A manufacturing method of a semiconductor device according to an embodiment includes a process of forming a preliminary cell region. The preliminary cell region includes a semiconductor substrate, a gate stacking structure on the semiconductor substrate, and a channel structure. The channel structure includes a channel penetration portion passing through the gate stacking structure, and a channel expanded portion on a first surface of the gate stacking structure in the semiconductor substrate and having a width or an area greater than a width or an area of the channel penetration portion. The manufacturing method of the semiconductor device according to the embodiment includes a process of boding the preliminary cell region on a circuit region, a process of removing the semiconductor substrate, a process of forming a cover insulation layer having an opening configured to expose the first surface of the gate stacking structure and the channel expanded portion, a process of removing a portion of a gate dielectric layer in the channel expanded portion on the first surface of the gate stacking structure, and a process of forming a common source layer on the first surface of the gate stacking structure and the channel expanded portion.

The gate dielectric layer may include a first dielectric portion in the channel penetration portion, and a second dielectric portion extending from the first dielectric portion in a horizontal direction at a portion adjacent to the first surface of the gate stacking structure.

Between the process of removing the portion of the gate dielectric layer and the process of forming the common source layer, a process of removing a portion of the channel layer adjacent to the channel expanded portion may be further included. In the process of forming the common source layer, the common source layer may be formed to fill an empty space formed by removing the portion of the channel layer.

The process of forming the cover insulation layer having the opening may include a process of forming the cover insulation layer and a process of forming the opening in the cover insulation layer.

In the process of forming the opening, the opening may be formed by sequentially performing a first etching process and a second etching process different from each other.

The first etching process may be a dry etching process, and the second etching process may be a wet etching process.

An opening portion may be formed in a portion of the cover insulation layer in a thickness direction of the cover insulation layer such that the channel expanded portion is not exposed in the first etching process, and the opening may be formed such that the channel expanded portion is exposed without exposing the channel penetration portion in the second etching process.

According to an embodiment, a cover insulation layer having an opening may be included and a structure selectively exposing at least a portion of a cell array region may be easily formed. The entirety of a side surface of a channel penetration portion and/or a channel extending portion may be surrounded by a gate dielectric layer and a structural stability of a channel structure including a channel expanded portion may be improved. A common source layer may be formed in an empty space formed by removing a portion of a channel layer adjacent to the channel expanded portion, and a cell current may be improved and a particle may be removed. Thereby, productivity and reliability of a semiconductor device may be improved.

### BRIEF DESCRIPTION OF THE DRAWINGS

FIG. 1 is a plan view schematically illustrating a semiconductor device according to an embodiment.
FIG. 2 is a partial cross-sectional view schematically illustrating the semiconductor device illustrated in FIG. 1.
FIG. 3 is an enlarged cross-sectional view illustrating a channel structure that is included in the semiconductor device illustrated in FIG. 2.
FIG. 4 a plan view illustrating a second surface of a gate stacking structure that is included in the semiconductor device illustrated in FIG. 2.
FIG. 5 is a cross-sectional view taken along a line C-C' in FIG. 4.
FIG. 6 is an enlarged cross-sectional view of a portion D in FIG. 3.
FIG. 7 is a graph illustrating a doping concentration in a direction E in FIG. 6.
FIG. 8 to FIG. 19 are cross-sectional views illustrating a manufacturing method of a semiconductor device according to an embodiment.
FIG. 20 is a cross-sectional view illustrating a portion of a semiconductor device according to an embodiment.
FIG. 21 is a cross-sectional view illustrating a portion of a semiconductor device according to an embodiment.
FIG. 22 is a cross-sectional view illustrating a portion of a semiconductor device according to an embodiment.
FIG. 23 to FIG. 26 are cross-sectional views illustrating a manufacturing method of the semiconductor device illustrated in FIG. 22.
FIG. 27 is a partial cross-sectional view schematically illustrating a semiconductor device according to an embodiment.
FIG. 28 schematically illustrates an electronic system including a semiconductor device according to an embodiment.
FIG. 29 is a perspective view schematically illustrating an electronic system including a semiconductor device according to an embodiment.
FIG. 30 is a cross-sectional view schematically illustrating a semiconductor package according to an embodiments.

### DETAILED DESCRIPTION

Embodiments of the present disclosure will be described more fully hereinafter with reference to the accompanying drawings for those skilled in the art to which the present disclosure pertains to easily practice the present disclosure. The present disclosure may be implemented in various different forms and is not limited to the embodiments provided herein.

A portion unrelated to the description is omitted in order to clearly describe the present disclosure, and same or similar components are denoted by a same reference numeral throughout the present specification.

Further, since a size and/or a thickness of a portion, a region, a member, a unit, a layer, a film, a substrate, or the like illustrated in the accompanying drawings may be arbitrarily illustrated for better understanding and convenience of explanation, the present disclosure is not limited to the illustrated size and/or thickness. In the drawings, a thickness of a portion, a region, a member, a unit, a layer, a film, a substrate, or the like may be enlarged or exaggerated for convenience of explanation and/or simple illustration.

It will be understood that when a component such as a portion, a region, a member, a unit, a layer, a film, a substrate, or the like is referred to as being "on" or "above" another component, it may be directly on another component or an intervening component may also be present. In contrast, when a component is referred to as being "directly on" another component, there is no intervening component. Further, when a component is referred to as being "on" or "above" a reference component, a component may be disposed on or below the reference component, and does not necessarily be "on" or "above" the reference component toward an opposite direction of gravity.

In addition, throughout the specification, unless explicitly described to the contrary, the word "comprise", "include", or "contain", and variations such as "comprises", "comprising", "includes", "including", "contains", or "containing" will be understood to imply the inclusion of other components rather than the exclusion of any other components.

Further, throughout the specification, a phrase "on a plane", "in a plane", "on a plan view", or "in a plan view" may indicate a case where a portion is viewed from above or a top portion, and a phrase "on a cross-section" or "in a cross-sectional view" may indicate a case where a cross-sectional view taken along a vertical direction is viewed from a side.

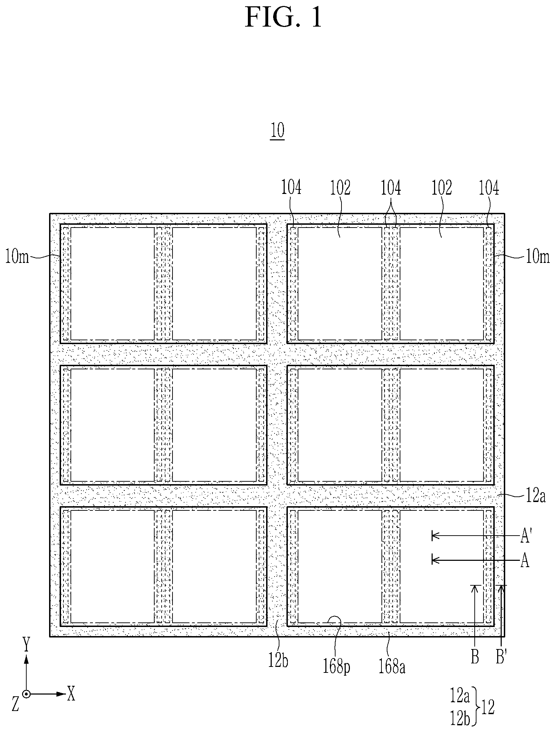

Hereinafter, referring to FIG. 1 to FIG. 19, a semiconductor device and a manufacturing method of the same according to an embodiment will be described in detail.

FIG. 1 is a plan view schematically illustrating a semiconductor device 10 according to an embodiment. FIG. 1 mainly illustrates a memory region 10m including a cell array region 102 and a connection region 104, an outer region 12, and a cover insulation layer 168a.

Referring to FIG. 1, in an embodiment, a semiconductor device 10 may include a plurality of memory regions 10m that are divided, partitioned, or defined by an outer region 12.

The memory region 10m may be a unit region of the semiconductor device 10, and may be referred to as a mat. In FIG. 1, it is illustrated as an example that the semiconductor device 10 includes a plurality of memory regions 10m that are adjacent to each other in a first direction (an X-axis direction in the drawings) and a plurality of memory regions 10m that are adjacent to each other in a second direction (a Y-axis direction in the drawings). However, the embodiments are not limited thereto, and a number, an arrangement, or so on of the plurality of memory regions 10m may be variously modified.

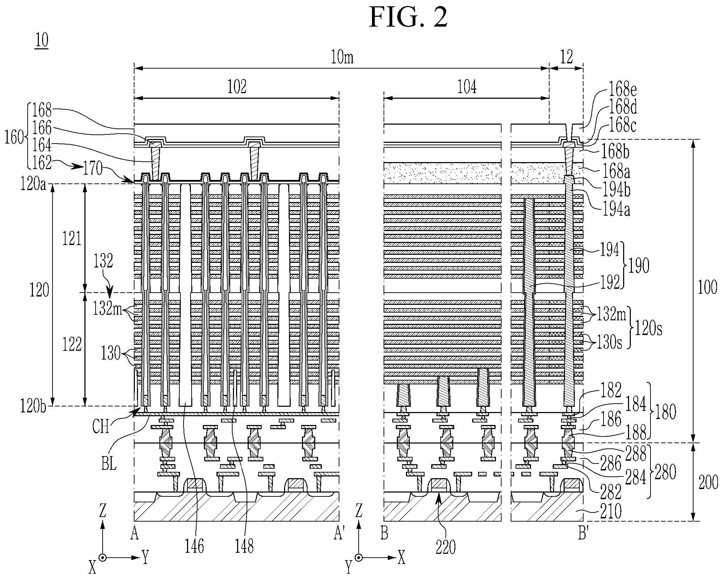

Each memory region 10m or each cell region 100 (refer to FIG. 2) may include a cell array region 102 and a connection region 104. In the cell array region 102, a gate stacking structure 120 (refer to FIG. 2) and a channel structure CH (refer to FIG. 2) may be provided. In the connection region 104, a plurality of gate contacts 192 (refer to FIG. 2) may be connected to a plurality of gate electrodes 130 (refer to FIG. 2) that are included in the gate stacking structure 120, respectively. In FIG. 1, it is illustrated as an example that, in each memory region 10m, a plurality of cell array regions 102 are included, and connection regions 104 are disposed at edge regions of each of the plurality of cell array regions 102 in the first direction (the X-axis direction in the drawings). However, the embodiments are not limited thereto. In some embodiments, in the first direction, one connection region 104 may be disposed in each memory region 10m, or the connection region 104 may be disposed at one side of the cell array region 102. Other various modified embodiments are possible.

The outer region 12 may be provided between the plurality of memory regions 10m to divide, partition, or define the plurality of memory regions 10m. The outer region 12 may include at least one first outer region 12a that longitudinally extends in the first direction (the X-axis direction in the drawings) and at least one second outer region 12b that longitudinally extends in the second direction (the Y-axis direction in the drawings). Thereby, a structure of the outer region 12 may be simplified. However, the embodiments are not limited thereto. The first and/or second outer region 12a and/or 12b may include a bent portion, a folded portion, a curved portion, a rounded portion, or so on according to an arrangement of the plurality of memory regions 10m.

In an embodiment, a cover insulation layer 168a may be disposed in the connection region 104 and/or the outer region 12 and may have an opening 168p exposing at least a portion of the cell array region 102, and a common source layer 170 (refer to FIG. 2) may be electrically connected to the channel structure CH through the opening 168p of the cover insulation layer 168a. This will be described later in more detail.

In FIG. 1, it is illustrated as an example that the opening 168p of the cover insulation layer 168a may have a rectangular planar shape. However, the embodiments are not limited thereto, and the opening 168p of the cover insulation layer 168a may have any of various planar shapes. In FIG. 1, it is illustrated as an example that, in each memory region 10m, the opening 168p of the cover insulation layer 168a may include a plurality of openings 168p corresponding the plurality of cell array regions 102, respectively. However, the embodiments are not limited thereto, and a number of the openings 168p of the cover insulation layer 168a may be variously modified in each memory region 10m.

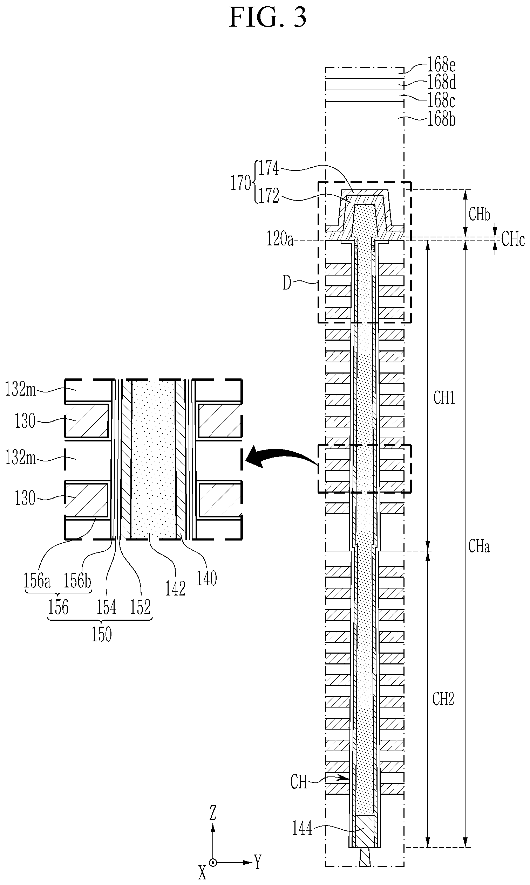

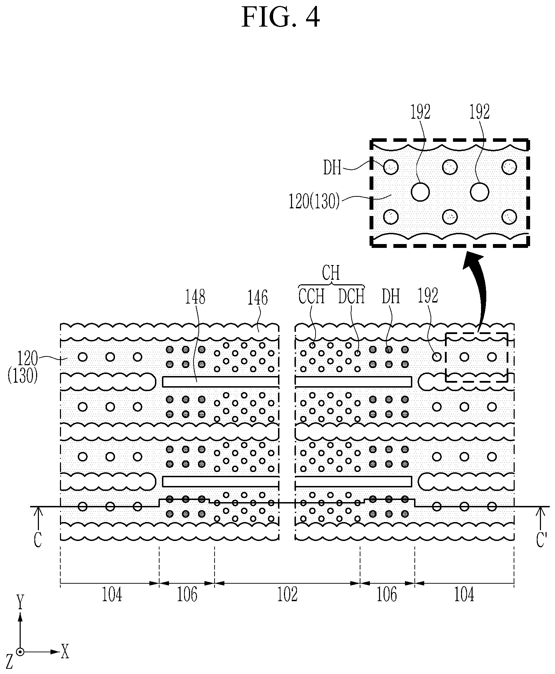

FIG. 2 is a partial cross-sectional view schematically illustrating the semiconductor device 10 illustrated in FIG. 1. FIG. 2 is a cross-sectional view taken along a line A-A' and a line B-B' in FIG. 1. For a clear understanding, a gate contact 192 and an input/output connection wiring 194 are illustrated together in FIG. 2, but positions of the gate contact 192 and the input/output connection wiring 194 may be variously modified. FIG. 3 is an enlarged cross-sectional view illustrating a channel structure CH that is included in the semiconductor device 10 illustrated in FIG. 2. FIG. 4 is a plan view illustrating a second surface 120b of a gate stacking structure 120 that is included in the semiconductor device 10 illustrated in FIG. 2.

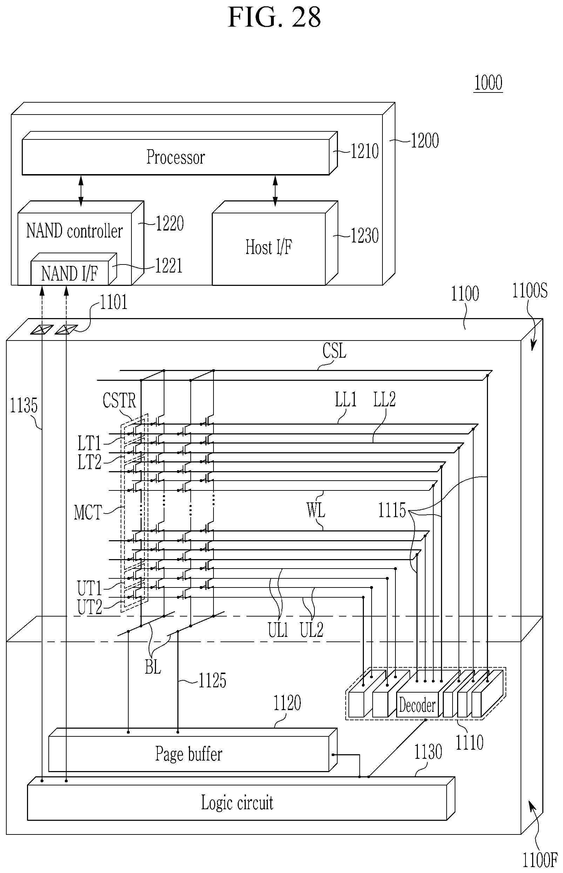

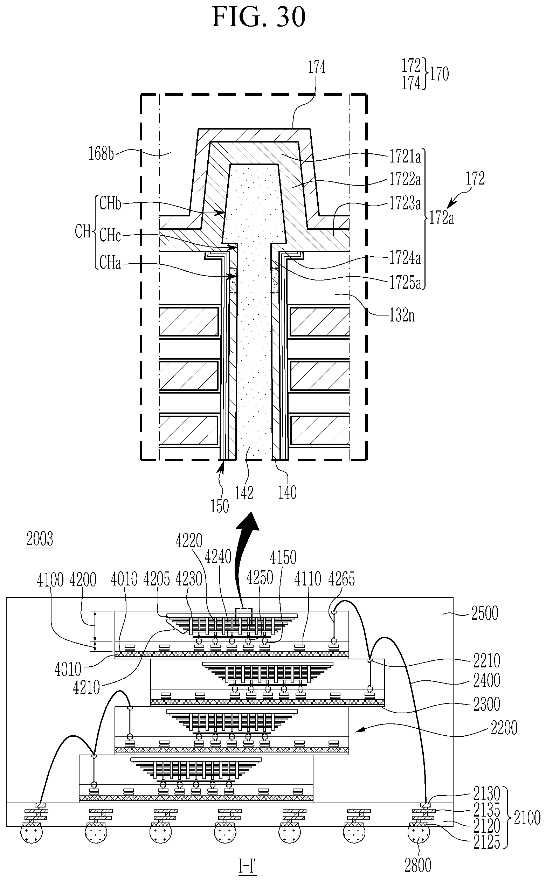

Referring to FIG. 2 to FIG. 4, the semiconductor device 10 according to an embodiment may include a cell region 100 that includes a memory cell structure and a circuit region 200 that includes a peripheral circuit structure configured to control an operation of the memory cell structure. For example, the circuit region 200 and the cell region 100 may correspond to a first structure 1100F and a second structure 1100S of a semiconductor device 1100 included in an electronic system 1000 illustrated in FIG. 28, respectively. For example, the circuit region 200 and the cell region 100 may be portions including a first structure 4100 and a second structure 4200 of a semiconductor chip 2200 illustrated in FIG. 30, respectively.

In an embodiment, the semiconductor device 10 may be a bonding semiconductor device formed by separately forming the cell region 100 and the circuit region 200 and thereafter bonding the cell region 100 to the circuit region 200. For example, the cell region 100 may be bonded to the circuit region 200 by a hybrid bonding process such as a chip to chip (C2C) bonding process, a chip-to-wafer bonding process, or a wafer-to-wafer bonding process. When the cell region 100 and the circuit region 200 are formed through separate processes, the cell region 100 may be prevented from affecting the circuit region 200 in the process of the cell region 100. For example, the semiconductor device 10 may be a bonding vertical NAND flash memory (BV NAND) flash memory.

In an embodiment, the cell region 100 may be disposed on the circuit region 200. Accordingly, an area corresponding to the circuit region 200 does not need to be provided separately from the cell region 100. Therefore, an area of the semiconductor device 10 may be reduced.

The circuit region 200 may be electrically connected to the cell region 100, and may include a substrate 210, a circuit element 220, and a circuit wiring portion 280. The substrate 210 may be a semiconductor substrate including a semiconductor material. For example, the substrate 210 may be a semiconductor substrate including or being formed of a semiconductor material or may be a semiconductor substrate in which a semiconductor layer is on a base substrate. For example, the substrate 210 may include or be formed of a semiconductor material (e.g., silicon, germanium, silicon-germanium, or the like) having a single-crystalline, epitaxial, or polycrystalline structure, silicon on insulator (SOI), germanium on insulator (GOI), or the like.

The circuit element 220 on the substrate 210 may include any of various circuit elements to constitute the peripheral circuit structure that controls an operation of the memory cell structure in the cell region 100. For example, the circuit element 220 may constitute the peripheral circuit structure such as a decoder circuit 1110 (refer to FIG. 28), a page buffer 1120 (refer to FIG. 28), a logic circuit 1130 (refer to FIG. 28), or the like.

The circuit element 220 may include, for example, a transistor, but the embodiments are not limited thereto. For example, the circuit element 220 may include not only an active element such as the transistor or the like but also a passive element such as a capacitor, a resistor, an inductor, or the like.

The circuit wiring portion 280 on the substrate 210 may be electrically connected to the circuit element 220. In an embodiment, the circuit wiring portion 280 may include a plurality of wiring layers 282 that are spaced apart from each other while interposing an insulation layer 286 therebetween and are electrically connected by a contact via 284 to form a desired path, and a bonding structure 288 that is electrically connected to the plurality of wiring layers 282. The wiring layers 282, the contact via 284, or the bonding structure 288 of the circuit wiring portion 280 may include any of various conductive materials, and the insulation layer 286 of the circuit wiring portion 280 may include any of various insulating materials.

The cell region 100 may include a gate stacking structure 120, a channel structure CH, a wiring portion (e.g., a first wiring portion 160, a second wiring portion 180, and/or a penetration wiring portion 190).

The cell region 100 may include a cell array region 102 and a connection region 104. In some embodiments, a buffer region 106 may be further provided between the cell array region 102 and the connection region 104. The buffer region 106 is separately described and illustrated from the cell array region 102 and the connection region 104 as an example for a clear understanding, but the buffer region 106 may be a portion of the cell array region 102 or a portion of the connection region 104.

In the cell array region 102, a memory cell structure may be disposed. For example, in the cell array region 102, the gate stacking structure 120 and the channel structure CH may be provided.

The gate stacking structure 120 may include a plurality of cell insulation layers 132 (e.g., a plurality of interlayer insulation layers 132m) and a plurality of gate electrodes 130 alternately stacked on each other. The channel structure CH may extend to pass through the gate stacking structure 120. For example, an extension direction of the channel structure CH may be a thickness direction of the semiconductor device 10, a vertical direction, or a Z-axis direction in the drawings.

The gate stacking structure 120 may have a first surface 120a and a second surface 120b opposite to each other. The second surface 120b of the gate stacking structure 120 may be a facing surface that faces the circuit region 200, and the first surface 120a of the gate stacking structure 120 may be an opposite surface that is opposite to the circuit region 200.

The gate electrode 130 may include any of various conductive materials. For example, the gate electrode 130 may include or be formed of a metal material (e.g., tungsten (W), titanium (Ti), tantalum (Ta), copper (Cu), aluminum (Al), cobalt (Co), ruthenium (Ru), or the like), polycrystalline silicon, metal nitride (e.g., tungsten nitride (WN), titanium nitride (TiN), tantalum nitride (TaN), or the like), or a combination thereof. The cell insulation layer 132 may include any of various insulating materials. For example, the interlayer insulation layer 132m may include or be formed of silicon oxide, silicon nitride, silicon oxynitride, a low dielectric constant material having a lower dielectric constant than silicon oxide, or a combination thereof.

The channel structure CH may include a channel layer 140, and a gate dielectric layer 150 on the channel layer 140 between the gate electrode 130 and the channel layer 140. The gate dielectric layer 150 between the gate electrode 130 and the channel layer 140 may include a tunneling layer 152, a charge storage layer 154, and a blocking layer 156 sequentially on the channel layer 140.

The channel structure CH may further include a core insulation layer 142 in the channel layer 140. In some embodiments, the core insulation layer 142 may be omitted. The channel structure CH may further include a channel pad 144 on the channel layer 140 and/or the core insulation layer 142.

Each channel structure CH may form one memory cell string, and a plurality of channel structures CH may be spaced apart from each other while forming rows and columns in a plan view. For example, a plurality of channel structures CH may be disposed to form any of various shapes such as a lattice shape, a zigzag shape, or the like in a plan view. The channel structure CH may have a pillar shape. For example, in a cross-sectional view, the channel structure CH may have an inclined side surface such that a width of the channel structure CH decreases toward the first surface 120a of the gate stacking structure 120 due to a high aspect ratio. However, the embodiments are not limited thereto, and an arrangement, a structure, a shape, or the like of the channel structure CH may be variously modified.

The channel layer 140 may include a semiconductor material. For example, the channel layer 140 may include a semiconductor material (e.g. silicon) having a polycrystalline or epitaxial structure. For example, the channel layer 140 may include an undoped semiconductor material, for example, undoped silicon. The core insulation layer 142 may include any of various insulating materials. For example, the core insulation layer 142 may include or be formed of silicon oxide, silicon nitride, silicon oxynitride, or a combination thereof.

The tunneling layer 152 may include an insulating material that is capable of tunneling a charge (e.g., silicon oxide, silicon oxynitride, or the like). The charge storage layer 154 may be used as a data storage region, and the charge storage layer 154 may include polycrystalline silicon, silicon nitride, or the like. The blocking layer 156 may include an insulating material that is capable of preventing an undesirable flow of charge into the gate electrode 130. For example, the blocking layer 156 may include silicon oxide, silicon nitride, silicon oxynitride, a high dielectric constant material having a higher dielectric constant than silicon oxide, or a combination thereof. In an embodiment, the blocking layer 156 may include a first blocking layer 156a that includes a portion horizontally extending on the gate electrode 130, and a second blocking layer 156b that vertically extends between the first blocking layer 156a and the charge storage layer 154.

The channel pad 144 may cover a surface of the core insulation layer 142 (e.g., a surface facing the circuit region 200) and may be electrically connected to the channel layer 140. The channel pad 144 may include a conductive material. For example, the channel pad 144 may include a semiconductor material doped with a dopant, for example, a polycrystalline or epitaxial semiconductor material (e.g., silicon) doped with a dopant.

However, the embodiments are not limited to a material, a structure, or the like of the channel layer 140, the core insulation layer 142, the gate dielectric layer 150, or the channel pad 144.

In an embodiment, the gate stacking structure 120 may include a plurality of gate stacking portions 121 and 122 that are sequentially stacked. Thereby, a number of stacked gate electrodes 130 may increase and thus a number of memory cells may increase with a stable structure. In FIG. 2, it is illustrated as an example that the gate stacking structure 120 includes a first gate stacking portion 121 and a second gate stacking portion 122. However, the embodiment are not limited thereto, and the gate stacking structure 120 may include one gate stacking portion or three or more gate stacking portions.

When the plurality of gate stacking portions 121 and 122 are provided as in the above, the channel structure CH (e.g., a channel penetration portion CHa) may include a plurality of channel portions CH1 and CH2 that respectively pass through the plurality of gate stacking portions 121 and 122. The plurality of channel portions CH1 and CH2 may be connected to each other. In a cross-sectional view, each of the plurality of channel portions CH1 and CH2 may have an inclined side surface such that a width of each of the plurality of channel portions CH1 and CH2 decreases toward the first surface 120a of the gate stacking structure 120 due to a high aspect ratio. A bent portion due to a difference in widths of the plurality of channel portions CH1 and CH2 may be provided at a boundary portion between the plurality of gate stacking portions 121 and 122. In some embodiments, the plurality of channel portions CH1 and CH2 may have an inclined side surface that continuously extends without the bent portion. In FIG. 3, it is illustrated as an example that each of the gate dielectric layer 150, the channel layer 140, and the core insulation layer 142 of the plurality of channel portions CH1 and CH2 continuously extends to have an integral structure. In some embodiments, gate dielectric layers 150, channel layers 140, and core insulation layers 142 of a plurality of channel portions CH1 and CH2 may be separately formed and be electrically connected to each other. In some embodiments, a separate channel pad may be additionally disposed at a connection portion of the plurality of channel portions CH1 and CH2. As such, the embodiments are not limited to a shape or a type of the plurality of channel portions CH1 and CH2.

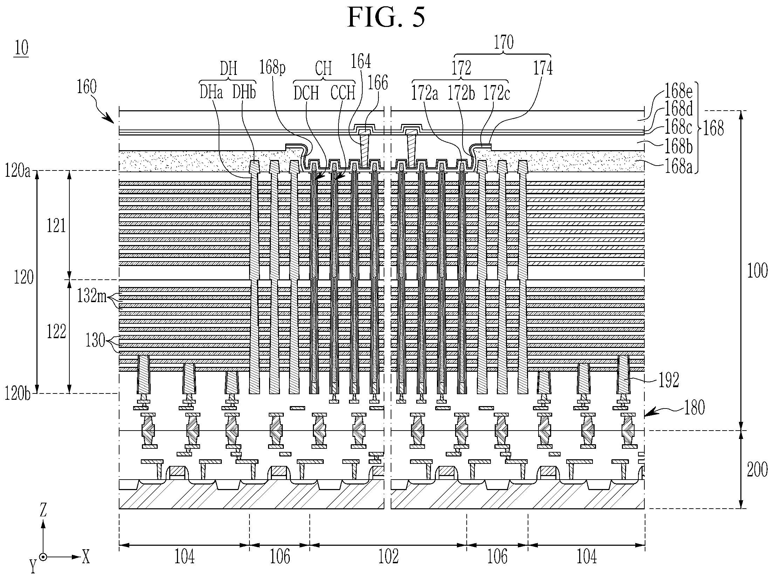

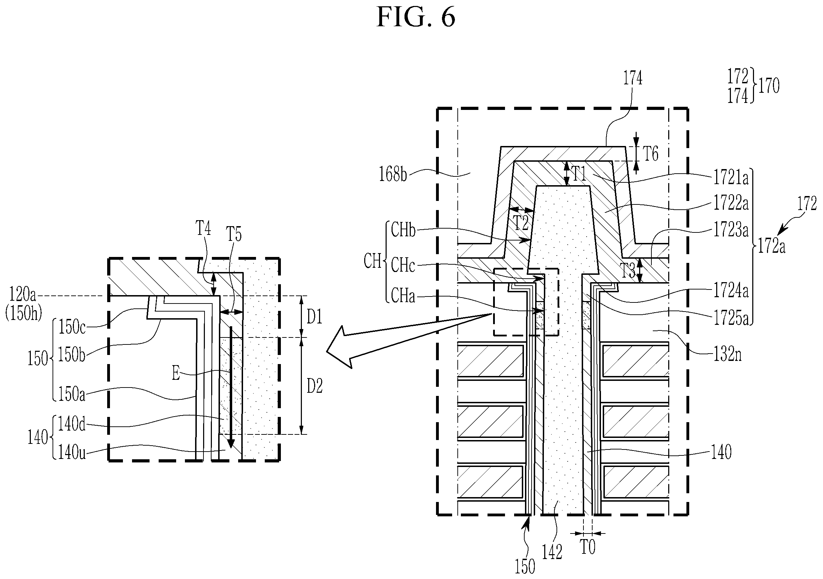

In an embodiment, the channel structure CH may include a channel penetration portion CHa and a channel expanded portion CHb, and may further include a channel extending portion CHc extending to connect the channel penetration portion CHa and the channel expanded portion CHb. This will be described later in more detail with reference to FIG. 5 and FIG. 6.

The channel structure CH in the cell array region 102 may include a connection channel structure CCH electrically connected to the first wiring portion 160 (e.g., a common source layer 170) and/or the second wiring portion 180 (e.g., a bit line BL). In an embodiment, in a region adjacent to the buffer region 106, the channel structure CH may further include a dummy channel structure DCH that is not electrically connected to the first wiring portion 160 (e.g., the common source layer 170) and/or the second wiring portion 180 (e.g., the bit line BL). In FIG. 5, it is illustrated as an example that the dummy channel structure DCH has a shape, a form, and a size same as a shape, a form, and a size of the connection channel structure CCH and is electrically connected to the common source layer 170 and is not electrically connected to the bit line BL. However, the embodiments are not limited thereto. In some embodiments, a gate dielectric layer and/or a channel layer may be disposed in a channel expanded portion of the dummy channel structure DCH, unlike the connection channel structure CCH, or the dummy channel structure DCH may not be electrically connected to the common source layer 170.

The buffer region 106 may be configured to improve a structural stability by minimizing a structural difference between the cell array region 102 and the connection region 104 in a manufacturing method of the semiconductor device 10. However, the embodiments are not limited thereto, and the buffer region 106 may be omitted.

In the buffer region 106, the gate stacking structure 120 and a dummy structure DH may be included. The dummy structure DH may be configured to alleviate a stress applied to the gate stack structure 120. The dummy structure DH may not be electrically connected to the wiring portion, unlike the channel structure CH (e.g., the connection channel structure CCH).

The dummy structure DH may include a dummy penetration portion DHa (refer to FIG. 5) and a dummy expanded portion DHb (refer to FIG. 5). The dummy penetration portion DHa may extend to pass through the gate stacking structure 120. The dummy expanded portion DHb may be disposed on the first surface 120a of the gate stacking structure 120 and may have a width or an area greater than a width or an area of the dummy penetration portion DHa. The width of the dummy penetration portion DHa or the dummy expanded portion DHb may refer to a width (e.g., a long width or a diameter) of a portion adjacent to the first surface 120a of the gate stacking structure 120. The area of the dummy penetration portion DHa or the dummy expanded portion DHb may refer to an area of a portion adjacent to the first surface 120a of the gate stacking structure 120.

In a cross-sectional view, the dummy penetration portion DHa may have an inclined side surface such that a width of the dummy penetration portion DHa decreases toward the first surface 120a of the gate stacking structure 120 due to a high aspect ratio. A bent portion due to a difference in widths of portions of the dummy penetration portion DHa may be provided at the boundary portion between the plurality of gate stacking portions 121 and 122. In some embodiments, the dummy penetration portion DHa may have an inclined side surface that continuously extends without the bent portion. However, the embodiments are not limited thereto, and the dummy structure DH may have any of various shapes or forms.

The dummy structure DH may include a material (e.g., an insulating material) different from a material of the channel structure CH, or may include a material same as a material of the channel structure CH. In FIG. 4, it is illustrated as an example that the dummy structure DH has a width or an area greater than a width or an area of the channel structure CH, and an interval between the dummy structures DH is greater than an interval between the channel structures CH. However, the embodiments are not limited thereto. In some embodiments, the dummy structure DH may have a width or an area same as or less than a width or an area of the channel structure CH, and/or an interval between the dummy structures DH may be same as or less than an interval between the channel structures CH.

The gate stacking structure 120 may be divided into a plurality of portions in a plan view by a separation structure 146 passing through the gate stacking structure 120. An separation pattern 148 may be disposed to be adjacent to the second surface 120b of the gate stacking structure 120. In a plan view, the separation structure 146 and/or the separation pattern 148 may extend in a first direction (a X-axis direction in the drawings). A plurality of separation structures 146 and/or a plurality of separation patterns 148 may be spaced apart from each other at predetermined intervals in a second direction (a Y-axis direction in the drawings) that intersects (e.g., is perpendicular to) the first direction.

In a plan view, by the separation structure 146, a plurality of gate stacking structures 120 may extend in the first direction (the X-axis direction in the drawings) and may be spaced apart from each other at predetermined intervals in the second direction (the Y-axis direction in the drawings) that intersects the first direction. The gate stacking structure 120 divided by the separation structure 146 may form one memory cell block. However, the embodiment are not limited thereto, and a range of the memory cell block is not limited thereto.

For example, the separation structure 146 may pass through the gate stacking structure 120, and the separation pattern 148 may separate one or a part of the plurality of gate electrodes 130. The separation pattern 148 may be disposed between the separation structures 146. In a cross-sectional view, the separation structure 146 or the separation pattern 148 may extend to pass through the gate stacking structure 120 in the thickness direction of the semiconductor device 10 or the vertical direction (the Z-axis direction in the drawings).

In FIG. 4, it is illustrated as an example that a side surface of the separation structure 146 has a shape in which curved surfaces of a convex curvature outward are disposed continuously. In FIG. 2, it is illustrated as an example that a bent portion is provided at the boundary portion between the plurality of gate stacking portions 121 and 122. A channel preliminary penetration part corresponding to the channel structure CH and a separation preliminary penetration part corresponding to the separation structure 146 may be formed together, and a penetration part for a separation structure may be formed by an etching process of expanding the separation preliminary penetration part such that separation preliminary penetration parts are connected to each other. Thereafter, a material may be filled in the penetration part for the separation structure to form the separation structure 146 having the above shape. Thereby, an etching process of additionally forming the penetration part for the separation structure having a high aspect ratio may be omitted, and thus, a manufacturing process may be simplified.

The separation preliminary penetration part corresponding to the separation structure 146 may include a penetration portion passing through the gate stacking structure 120 and an expanded portion on the first surface 120a of the gate stacking structure 120. The expanded portion may have a width or an area greater than a width or an area of the penetration portion. In the process of forming the penetration part for the separation structure by expanding the separation preliminary penetration part, a width or an area of the penetration portion may increase, and the penetration portion in the penetration part for the separation structure may have a width or an area greater than a width or an area of the expanded portion in the penetration part for the separation structure. After forming the separation structure 146, at least a portion of the expanded portion on the first surface 120a of the gate stacking structure 120 may be removed in a process of removing a portion of the gate dielectric layer 150. Thereby, in a final structure, the separation structure 146 may include the penetration portion passing through the gate stacking structure 120, and may not include at least a portion of the expanded portion.

However, the embodiments are not limited thereto. In some embodiments, in a cross-sectional view, the separation structure 146 may have an inclined side surface such that a width of the separation structure 146 decreases toward the first surface 120a of the gate stacking structure 120 due to a high aspect ratio. A bent portion due to a difference in widths of portions of the separation structure 146 may be provided at the boundary portion between the plurality of gate stacking portions 121 and 122. In some embodiments, the separation structure 146 may have a side surface parallel to the thickness direction of the semiconductor device 10 or the vertical direction (the Z-axis direction in the drawings), or may have an inclined side surface that continuously extends without the bent portion. In some embodiments, the separation structure 146 may include the penetration portion passing through the gate stacking structure 120, and may further include at least a portion of the expanded portion. The separation structure 146 may have any of other various shapes.

The separation structure 146 and/or the separation pattern 148 may include any of various insulating materials. For example, the separation structure 146 or the separation pattern 148 may include or be formed of an insulating material such as silicon oxide, silicon nitride, or silicon oxynitride. However, the embodiment are not limited thereto, and a structure, a shape, or the like of the separation structure 146 or the separation pattern 148 may be variously modified.

The connection region 104 and/or the outer region 12, and the wiring portion may be provided to connect the memory cell structure (e.g., the gate stacking structure 120 and the channel structure CH) in the cell array region 102 to the circuit region 200 or an external circuit.

In an embodiment, the wiring portion may include any of members configured to electrically connect the gate electrode 130 and/or the channel structure CH to the circuit region 200 or the external circuit. The wiring portion may include a first wiring portion 160 on the first surface 120a of the gate stacking structure 120, a second wiring portion 180 on the second surface 120b of the gate stacking structure 120 (e.g., between the second surface 120b of the gate stacking structure 120 and the circuit region 200), and a penetration wiring portion 190 in the connection region 104 and/or the outer region 12.

In an embodiment, the first wiring portion 160 may include the common source layer 170, the second wiring portion 180 may include a bit line BL and a bonding structure 188, and the penetration wiring portion 190 may include a gate contact 192 and an input/output connection wiring 194.

In an embodiment, the first wiring portion 160 may include a first wiring layer 162 on the first surface 120a of the gate stacking structure 120, a first contact 164 electrically connected to the first wiring layer 162, a pad 166 electrically connected to the first contact 164, and an insulation layer 168.

The first wiring layer 162 may include a common source layer 170 electrically connected to the channel structure CH on the first surface 120a of the gate stacking structure 120. The first contact 164 may include a common source contact electrically connected to the common source layer 170 and an input/output connection contact electrically connected to the input/output connection wiring 194. For example, the common source contact may electrically connect the common source layer 170 and the pad 166, and the input/output connection contact may electrically connect the input/output connection wiring 194 and the pad 166.

The insulation layer 168 of the first wiring portion 160 may include a cover insulation layer 168a, and may further include first to fourth insulation layers 168b, 168c, 168d, and 168e on the cover insulation layer 168a. The cover insulation layer 168a may have an opening 168p (refer to FIG. 5) exposing at least a portion of the cell array region 102.

The cover insulation layer 168a may have the opening 168p exposing at least a portion of the cell array region 102, and may be disposed on at least the connection region 104, the buffer region 106, and/or the outer region 12. The cover insulation layer 168a may be disposed on the first surface 120a of the gate stacking structure 120. For example, a surface (a lower surface in FIG. 2) of the cover insulation layer 168a adjacent to the first surface 120a of the gate stacking structure 120 may be on a same plane as a surface (a lower surface in FIG. 2) of the common source layer 170 adjacent to the first surface 120a of the gate stacking structure 120, for example, a surface of a first portion 172a (refer to FIG. 5) of a first common source layer 172 (refer to FIG. 5). However, the embodiments are not limited thereto. In some embodiments, the surface of the cover insulation layer 168a adjacent to the first surface 120a of the gate stacking structure 120 may be on a plane different from the surface of the common source layer 170 adjacent to the first surface 120a of the gate stacking structure 120.

The opening 168p of the cover insulation layer 168a may be disposed in at least a portion of the cell array region 102 in which the channel structure CH and the common source layer 170 are electrically connected to each other. Thereby, at least a portion of the cell array region 102 in which the channel structure CH and the common source layer 170 are electrically connected to each other may be physically or structurally separated from another region. For example, the opening 168p of the cover insulation layer 168a may expose a portion of the cell array region 102, and the cover insulation layer 168a may be disposed in the connection region 104, the buffer region 106, and/or the outer region 12. Thereby, the portion of the cell array region 102 may be physically or structurally separated from the connection region 104, the buffer region 106, and/or the outer region 12.

In an embodiment, in a manufacturing process of the semiconductor device 10, the cover insulation layer 168a may protect the connection region 104, the buffer region 106, and/or the outer region 12. For example, in a process of electrically connecting the common source layer 170 and the channel structure CH, the cover insulation layer 168a may protect a structure (e.g., the wiring portion) in the connection region 104, the buffer region 106, and/or the outer region 12. That is, in a process of removing a portion of the gate dielectric layer 150 in the channel expanded portion CHb of the channel structure CH, the cover insulation layer 168a may act as a mask layer. Accordingly, in a state that the cover insulation layer 168a protects the connection region 104, the buffer region 106, and/or the outer region 12, the portion of the gate dielectric layer 150 in the channel expanded portion CHb of the channel structure CH may be selectively removed. In a heat treatment process of the common source layer 170 (e.g., the first common source layer 172), the cover insulation layer 168a may absorb energy and heat and may prevent metal from diffusing to the wiring portion in or at a lower portion of the connection region 104 and/or the outer region 12.

The cover insulation layer 168a may include an insulating material. When the cover insulation layer 168a includes an insulating material, a manufacturing process may be simplified, and the cover insulation layer 168a may stably protect the connection region 104, the buffer region 106, and/or the outer region 12. In a comparative example in which a cover layer including a semiconductor material or a metallic material other than an insulating material is included, instead of the cover insulation layer 168a, the cover layer may be formed in a process of forming a preliminary cell region and/or a process of removing the cover layer may be additionally performed in a subsequent process in consideration of a wiring portion or the like. Accordingly, this may be disadvantageous in a manufacturing process. Further, the cover layer including the semiconductor material or the metallic material may remain, which may be disadvantageous in performance.

In an embodiment, the cover insulation layer 168a may include or be formed of silicon, silicon oxide, silicon carbide, silicon nitride, silicon oxynitride, or the like, and may include a material different from a material of the cell insulation layer 132 (e.g., the interlayer insulation layer 132m). For example, the interlayer insulation layer 132m may include or be formed of silicon oxide, and the cover insulation layer 168a may include or be formed of silicon nitride. Thereby, in the process of removing the portion of the gate dielectric layer 150 in the process of electrically connecting the common source layer 170 and the channel structure CH, an etching process may be stably stopped. However, the embodiments are not limited thereto.

In an embodiment, by using the cover insulation layer 168a including the insulating material, a region in which the channel structure CH and the common source layer 170 are electrically connected to each other may be separated from another region, and a manufacturing process of the semiconductor device 10 may be simplified and a structural stability of the semiconductor device 10 may be improved.

The common source layer 170 may be electrically connected to the channel structure CH (e.g., to the channel layer 140) exposed by the opening 168p of the cover insulation layer 168a in the cell array region 102.

The common source layer 170 may include a first common source layer 172 and a second common source layer 174. The first common source layer 172 may include a doped semiconductor layer (e.g., an n-type or p-type polycrystalline silicon layer), and the second common source layer 174 may include metal. The first common source layer 172 may include a semiconductor material to improve a connection property to the channel layer 140. The second common source layer 174 may include metal having an electrical resistance less than an electrical resistance of the first common source layer 172 to reduce an electrical resistance of the common source layer 170. However, the embodiments are not limited thereto, and the first common source layer 172 or the second common source layer 174 may be omitted, or the common source layer 170 may include a layer other than the first common source layer 172 and the second common source layer 174.

The first insulation layer 168b may be a kind of a planarization layer covering the cover insulation layer 168a and the common source layer 170. The second insulation layer 168c and the third insulation layer 168d may be insulation layers for hydrogen passivation, and the fourth insulation layer 168e may be a capping layer configured to protect the semiconductor device 10. The first to fourth insulation layers 168b, 168c, 168d, and 168e may include or be formed of any of various insulating materials, for example, silicon oxide, silicon nitride, silicon oxynitride, silicon carbide, an organic material, or the like. For example, the second insulation layer 168c may include an insulating material layer including hydrogen (e.g., a silicon oxide layer including hydrogen), and the third insulation layer 168d may include a barrier layer (e.g., a silicon nitride layer). The hydrogen included in the second insulation layer 168c may be diffused to the channel layer 140 of the channel structure CH by a heat treatment process, and the channel layer 140 may be passivated by the hydrogen.

However, the embodiments are not limited thereto. At least one of the first to fourth insulation layers 168b, 168c, 168d, and 168e may be omitted, or an insulation layer other than the first to fourth insulation layers 168b, 168c, 168d, and 168e may be further included.

In an embodiment, the second wiring portion 180 may include a second wiring layer 182, a second contact 184, a bonding structure 188, and an insulation layer 186. The second wiring layer 182 may be disposed on the second surface 120b of the gate stacking structure 120. The second contact 184 may be electrically connected to the second wiring layer 182. The bonding structure 188 may be electrically connected to the second wiring layer 182 at a portion facing the circuit region 200.

The second wiring layer 182 may include a bit line BL, and the second contact 184 may include a bit line contact that electrically connects the channel pad 144 of the channel structure CH and the bit line BL. The second wiring layer 182 may further include a connection wiring electrically connected to the gate contact 192, the input/output connection wiring 194, or the like. The insulation layer 186 of the second wiring portion 180 may include an interlayer insulation layer and a bonding insulation layer. The interlayer insulation layer may be disposed at a periphery of the second wiring layer 182 and/or the second contact 184. The bonding insulation layer may be disposed at a periphery of the bonding structure 188 in a portion facing the circuit region 200.

The first wiring layer 162, the first contact 164, the pad 166, the second wiring layer 182, or the second contact 184 may include any of various conductive materials, and the insulation layer 168 of the first wiring portion 160 or the insulation layer 186 of the second wiring portion 180 may include any of various insulating materials. For example, the first wiring layer 162, the first contact 164, the pad 166, the second wiring layer 182, or the second contact 184 may include a metallic material (e.g., tungsten (W), titanium (Ti), tantalum (Ta), copper (Cu), aluminum (Al), cobalt (Co), ruthenium (Ru), or the like), a semiconductor material (e.g., polycrystalline silicon), metal nitride (e.g., tungsten nitride (WN), titanium nitride (TiN), tantalum nitride (TaN), or the like), or combination thereof.

In an embodiment, in the connection region 104, the plurality of gate electrodes 130 may extend in the first direction (the X-axis direction in the drawings), and the plurality of gate contacts 192 may pass through the gate stacking structure 120 or the cell insulation layer 132 and may be electrically connected to the plurality of gate electrodes 130, respectively, extending to the connection region 104.

For example, in the connection region 104, a plurality of contact holes where the plurality of gate contacts 192 are disposed, respectively, may be individually provided in the gate stacking structure 120, and the gate stacking structure 120 may be entirely disposed in a portion other than the separation structure 146 and/or the separation pattern 148. For example, in the connection region 104, extension lengths of the plurality of gate electrodes 130 may be substantially same. Substantially same may refer to have a difference within a process error (e.g., less than 10%). In an embodiment, a portion (e.g., a pad region) in which the gate stacking structure 120 is removed to have a stair shape for an electrical connection between the gate electrode 130 and the gate contact 192 or an insulation layer (e.g., a pad insulation layer) in the portion (e.g., the pad region) may not be provided. Accordingly, a process of electrically connecting the gate contact 192 and the gate electrode 130 may be simplified, and an area of the connection region 104 may be reduced.

However, the embodiments are not limited thereto. In some embodiments, extension lengths of the plurality of gate electrodes 130 may sequentially decrease far away from the first surface 120a of the gate stacking structure 120 in the connection region 104. For example, the plurality of gate electrodes 130 may have a stair shape in one direction or a plurality of directions in the connection region 104, and a portion (e.g., a pad region) in which the gate stacking structure 120 is removed to have a stair shape may be included. The plurality of gate contacts 192 may pass through a cell insulation layer 132 (e.g., a pad insulation layer) in the pad region and may be electrically connected to the plurality of gate electrodes 130, respectively. An electrical connection structure between the gate electrode 130 and the gate contact 192 may be variously modified.

In the connection region 104, the dummy structure DH may be provided at a periphery of the gate contact 192. The dummy structure DH may be configured to alleviate a stress applied to the gate stack structure 120.

In FIG. 2, it is illustrated as an example that the input/output connection wiring 194 is disposed in the outer region 12 where an insulation stacking structure 120s is disposed and passes through the insulation stacking structure 120s.

The insulation stacking structure 120s may include a plurality of cell insulation layers 132 (e.g., a plurality of interlayer insulation layers 132m) and a plurality of sacrificial insulation layers 130s alternately stacked on each other. The plurality of sacrificial insulation layers 130s of the insulation stacking structure 120s may correspond to the plurality of gate electrodes 130 of the gate stacking structure 120, respectively, and the plurality of interlayer insulation layers 132m of the insulation stacking structure 120s may correspond to the plurality of interlayer insulation layers 132m of the gate stacking structure 120, respectively. The sacrificial insulation layer 130s may include a material different from a material of the cell insulation layer 132 (e.g., the interlayer insulation layer 132m). For example, the sacrificial insulation layer 130s may include or be formed of silicon, silicon oxide, silicon carbide, silicon nitride, silicon oxynitride, or the like, and may include a material different from a material of the cell insulation layer 132 (e.g., the interlayer insulation layer 132m).

The plurality of interlayer insulation layers 132m of the insulation stacking structure 120s may be insulation layers formed by a same process as the plurality of interlayer insulation layers 132m of the gate stacking structure 120. After forming the insulation stacking structure 120s by alternately stacking the plurality of interlayer insulation layers 132m and the plurality of sacrificial insulation layers 130s in the cell array region 102, the buffer region 106, the connection region 104, and the outer region 12, the plurality of sacrificial insulation layers 130s may be selectively removed in the cell array region 102, the buffer region 106, and at least a portion of the connection region 104, and the gate electrode 130 may be formed in portions where the sacrificial insulation layer 130s are removed. Accordingly, the gate stacking structure 120 including the plurality of interlayer insulation layers 132m and the plurality of gate electrodes 130 alternately stacked on each other may be disposed in the cell array region 102, the buffer region 106, and at least a portion of the connection region 104, and the insulation stacking structure 120s including the plurality of interlayer insulation layers 132m and the plurality of sacrificial insulation layers 130s alternately stacked on each other may be disposed in the outer region 12.

However, the embodiments are not limited thereto. In some embodiments, in a portion where the input/output connection wiring 194 is disposed, the gate stacking structure 120 and the insulation stacking structure 120s may not be disposed and the cell insulation layer 132 may be disposed, and the input/output connection wiring 194 may pass through the cell insulation layer 132.

In FIG. 2, it is illustrated as an example that the input/output connection wiring 194 includes a wiring penetration portion 194a and a wiring expanded portion 194b. The wiring penetration portion 194a may extend to pass through the gate stacking structure 120. The wiring expanded portion 194b may be disposed on the first surface 120a of the gate stacking structure 120 and may have a width or an area greater than a width or an area of the wiring penetration portion 194a. The width of the wiring penetration portion 194a or the wiring expanded portion 194b may refer to a width (e.g., a long width or a diameter) of a portion adjacent to the first surface 120a of the gate stacking structure 120. The area of the wiring penetration portion 194a or the wiring expanded portion 194b may refer to an area of a portion adjacent to the first surface 120a of the gate stacking structure 120. However, the embodiments are not limited thereto, and the input/output connection wiring 194 may have any of various shapes or forms.

In FIG. 2, it is illustrated as an example that, in a cross-sectional view, the gate contact 192 and/or the input/output connection wiring 194 (e.g., the wiring penetration portion 194a) has an inclined side surface such that a width of the gate contact 192 and/or the input/output connection wiring 194 decreases toward the first surface 120a of the gate stacking structure 120 due to a high aspect ratio. A bent portion due to a difference in widths of portions of the gate contact 192 and/or the input/output connection wiring 194 may be provided at the boundary portion between the plurality of gate stacking portions 121 and 122. However, the embodiments are not limited thereto. The gate contact 192 and/or the input/output connection wiring 194 may not include the bent portion at the boundary portion between the plurality of gate stacking portions 121 and 122. Other various modified embodiments are possible.

The input/output connection wiring 194 may be electrically connected to the pad 166 included in the cell region 100. In FIG. 2, it is illustrated as an example that the input/output connection wiring 194 is electrically connected to the pad 166 through an input/output connection contact that passes through the insulation layer 168 of the first wiring portion 160. However, the embodiment are not limited thereto, and the pad 166 and the input/output connection wiring 194 may be electrically connected to each other by any of various structures. The input/output connection wiring 194 may be electrically connected to a part of the bonding structures 188 of the second wiring portion 180. In some embodiments, an additional input/output pad electrically connected to the circuit region 200 may be provided.

In an embodiment, the cell region 100 and the circuit region 200 may be bonded to each other by hybrid bonding. For example, the cell region 100 and the circuit region 200 may be bonded to each other by hybrid bonding including metal bonding between the bonding structures 188 and 288 and including insulation-layer bonding between bonding insulation layers at a periphery of the bonding structures 188 and 288.

For example, the bonding structure 188 of the cell region 100 and/or the bonding structure 288 of the circuit region 200 may include or be formed of at least one of copper, aluminum, tungsten, nickel, gold, tin, manganese, cobalt, titanium, tantalum, ruthenium and beryllium or may include or be formed of an alloy including the above material. For example, the bonding structure 188 of the cell region 100 and the bonding structure 288 of the circuit region 200 may include copper so that the cell region 100 and the circuit region 200 may be bonded (e.g., directly bonded) to each other by copper-to-copper bonding.

For example, the bonding insulation layer of the cell region 100 and the bonding insulation layer of the circuit region 200 may include a same insulating material. For example, the bonding insulation layer of the cell region 100 and the bonding insulation layer of the circuit region 200 may include a layer including or being formed of silicon carbonitride at least at a boding surface. However, the embodiments are not limited thereto. The bonding insulation layer of the cell region 100 and/or the bonding insulation layer of the circuit region 200 may include a material same as or different from a material of the cell insulation layer 132 of the cell region 100 or the insulation layer 286 the circuit region 200.

In an embodiment, by the wiring portion of the cell region 100 and the circuit wiring portion 280, the bit line BL connected to the channel structure CH and/or the gate electrode 130 may be electrically connected to the circuit element 220 of the circuit region 200.

Referring to FIG. 5 to FIG. 7 together with FIG. 2 and FIG. 4, the channel structure CH and the first wiring portion 160 according to an embodiment will be described in more detail.

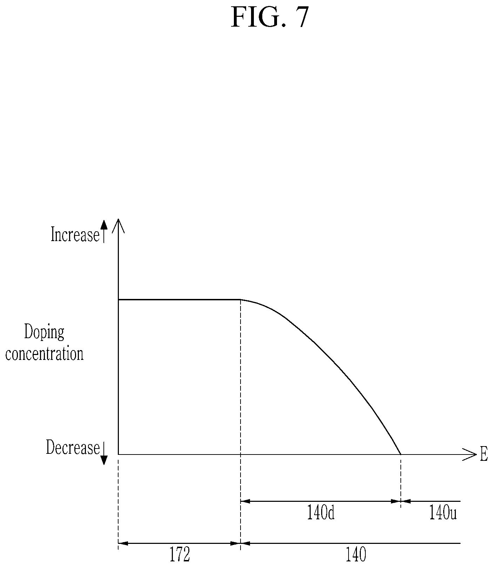

FIG. 5 is a cross-sectional view taken along a line C-C' in FIG. 4. FIG. 6 is an enlarged cross-sectional view of a portion D in FIG. 3. FIG. 7 is a graph illustrating a doping concentration in a direction E in FIG. 6. For simple illustration, in FIG. 5, it is illustrated as an example that the channel structure CH and the dummy structure DH have a same width. However, the embodiments are not limited thereto, and the channel structure CH and the dummy structure DH may have different widths or areas, as illustrated in FIG. 4.

Referring to FIG. 2, FIG. 4 to FIG. 7, in an embodiment, a side surface of the cover insulation layer 168a in which the opening 168p is disposed may include a rounded portion or a portion having a concave shape. At least a portion of the opening 168p in the cover insulation layer 168a may be formed by a wet etching process of an isotropic etching, and the side surface of the cover insulation layer 168a in which the opening 168p is disposed may include the rounded portion or have the concave shape.

In an embodiment, the wet etching process may be used in the process of forming the opening 168p in the cover insulation layer 168a, and the opening 168p may be stably formed at a desired position by an easy process. This will be described later in more detail in a manufacturing method of the semiconductor device 10.

In an embodiment, the channel structure CH may include a channel penetration portion CHa and a channel expanded portion CHb, and may further include a channel extending portion CHc extending to connect the channel penetration portion CHa and the channel expanded portion CHb.

The channel penetration portion CHa may extend to pass through the gate stacking structure 120. The channel expanded portion CHb may be disposed on the first surface 120a of the gate stacking structure 120 and may have a width or an area greater than a width or an area of the channel penetration portion CHa. The channel extending portion CHc may extend to connect the channel penetration portion CHa and the channel expanded portion CHb on the first surface 120a of the gate stacking structure 120, and may have a width or an area less than a width or an area of the channel expanded portion CHb. The width of the channel penetration portion CHa, the channel expanded portion CHb, or the channel extending portion CHc may refer to a width (e.g., a long width or a diameter) of a portion adjacent to the first surface 120a of the gate stacking structure 120. The area of the channel penetration portion CHa, the channel expanded portion CHb, or the channel extending portion CHc may refer to an area of a portion adjacent to the first surface 120a of the gate stacking structure 120.

The channel penetration portion CHa may be disposed in the gate stacking structure 120, and may include a gate dielectric layer 150, a channel layer 140, and a core insulation layer 142.

The channel expanded portion CHb may be disposed on the first surface 120a of the gate stacking structure 120, and may include the core insulation layer 142 without the gate dielectric layer 150 and the channel layer 140.

The channel extending portion CHc may be a portion in which a portion of the channel layer 140 between the channel penetration portion CHa and the channel expanded portion CHb is removed. The channel extending portion CHc may have a shape extending from the channel penetration portion CHa and may be adjacent to the channel expanded portion CHb. For example, a side surface of the channel extending portion CHc may include a surface (e.g., an inclined surface) continuously extending from a side surface of the channel penetration portion CHa. The channel extending portion CHc may include the core insulation layer 142 without the gate dielectric layer 150 and the channel layer 140.

In the extension direction of the channel structure CH (the Z-axis direction in the drawings), a length (e.g., a height) of the channel extending portion CHc may be substantially same as a thickness T0 of the channel layer 140. For example, the length of the channel extending portion CHc may be in a range of 90% to 110% of the thickness T0 of the channel layer 140. However, the embodiments are not limited thereto. In some embodiments, if the channel extending portion CHc may be the portion in which the portion of the channel layer 140 is removed, the length of the channel extending portion CHc may be different from the thickness T0 of the channel layer 140. In the extension direction of the channel structure CH (the Z-axis direction in the drawings), the length of the channel extending portion CHc may be less than a thickness of the gate dielectric layer 150. However, the embodiments are not limited thereto.

The core insulation layer 142 may be disposed in the channel penetration portion CHa, the channel extending portion CHc, and the channel expanded portion CHb. The core insulation layer 142 in the channel expanded portion CHb may include a portion having a width or an area greater than a width or an area of the core insulation layer 142 in each of the channel penetration portion CHa and the channel extending portion CHc. The core insulation layer 142 in the channel extending portion CHc may have a shape extending from the core insulation layer 142 in the channel penetration portion CHa.

The gate dielectric layer 150 may include a first dielectric portion 150a and a second dielectric portion 150b. The first dielectric portion 150a may extend in the channel penetration portion CHa in the extension direction of the channel structure CH (the Z-axis direction in the drawings). The second dielectric portion 150b may expand from the first dielectric portion 150a in a horizontal direction (a direction parallel to an XY plane in the drawings). The second dielectric portion 150b may be disposed at a side of the first surface 120a of the gate stacking structure 120 or may be adjacent to the first surface 120a of the gate stacking structure 120. The gate dielectric layer 150 may further include a third dielectric portion 150c extending from the second dielectric portion 150b to be parallel to a side surface of the channel expanded portion CHb. The second dielectric portion 150b may have a shape bent from the first dielectric portion 150a, and the third dielectric portion 150c may have a shape bent from the second dielectric portion 150b.

A portion of the gate dielectric layer 150 exposed on the first surface 120a of the gate stacking structure 120 may be removed, and a portion of the gate dielectric layer 150 on a side surface of the channel penetration portion CHa below the first surface 120a of the gate stacking structure 120 may not be removed to form the gate dielectric layer 150 including the first dielectric portion 150a, the second dielectric portion 150b, and/or the third dielectric portion 150c.

In an embodiment, the gate dielectric layer 150 may include the first dielectric portion 150a and the second dielectric portion 150b, and the gate dielectric layer 150 may surround the entirety of the side surface of the channel penetration portion CHa such that the side surface of the channel penetration portion CHa is not exposed. Accordingly, by the gate dielectric layer 150, the channel extending portion CHc or the channel penetration portion CHa may not include a portion in which a width of the portion is largely reduced compared to another portion. That is, the gate dielectric layer 150 may be disposed in the channel extending portion CHc the channel penetration portion CHa adjacent to the channel expanded portion CHb, and may stably support the channel expanded portion CHb to improve a structural stability of the channel structure CH. For example, cutting or separation of the channel structures CH or a particle from the channel structures CH thereby may be minimized in a portion adjacent to the channel expanded portion CHb. Accordingly, a structural stability of the channel structure CH may be improved and a defect may be minimized without a new process or a new facility.

On the other hand, in a comparative example in which a portion of a gate dielectric layer on a side surface of a channel penetration portion is removed in a removal process of removing a portion of the gate dielectric layer, a portion of the channel penetration portion in which the gate dielectric layer is removed may have a large length (e.g., a length same as or greater than a sum of a thickness of a channel layer and a thickness of the gate dielectric layer) in an extension direction of a channel structure. Thereby, the portion of the channel penetration portion adjacent to a channel expanded portion and having a largely reduced width or area may have a relatively large length, and the channel penetration portion may be difficult to stably support the channel expanded portion. Accordingly, the portion of the channel penetration portion adjacent to the channel expanded portion may be cut or separated, and a particle may be formed by the cutting or the separation of the portion of the channel penetration portion. If the particle may be induced by the cutting or the separation of the channel structure, a defect in which the channel structure and a common source layer are not electrically connected to each other may occur.

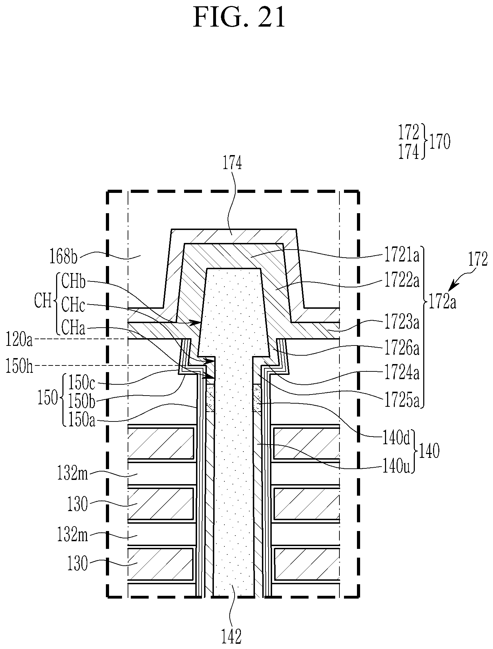

In FIG. 6, it is illustrated as an example that the first surface 120a of the gate stacking structure 120 and a first surface 150h (an upper surface in FIG. 6) of the second dielectric portion 150b and a first surface (an upper surface in FIG. 6) of the third dielectric portion 150c adjacent thereto are on a same plane. For example, the first surface 120a of the gate stacking structure 120 may be spaced apart from the channel expanded portion CHb. In the extension direction of the channel structure CH (the Z-axis direction in the drawings), a distance between the first surface 120a of the gate stacking structure 120 and the channel expanded portion CHb may be a thickness of the channel layer 140. However, the embodiments are not limited thereto. An embodiment will be described later in detail referring to FIG. 21.

In an embodiment, the channel layer 140 may be disposed to correspond to a portion of the channel penetration portion CHa, and may not disposed in another portion of the channel penetration portion CHa, the channel extending portion CHc, and the channel expanded portion CHb. For example, the channel layer 140 may be between the core insulation layer 142 and the gate dielectric layer 150 in a portion of the channel penetration portion CHa. The channel layer 140 may not be disposed between the core insulation layer 142 and the gate dielectric layer 150 in another portion of the channel penetration portion CHa and the channel extending portion CHc, and may not be disposed on the core insulation layer 142 in the channel expanded portion CHb.

The channel layer 140 may be connected to (e.g., in contact with) a portion of the common source layer 170 in the channel penetration portion CHa. This will be described after the common source layer 170 is described.

The common source layer 170 may be electrically connected to the channel expanded portion CHb of the channel structure CH on the first surface 120a of the gate stacking structure 120 exposed by the opening 168p. The common source layer 170 may include a first common source layer 172 and a second common source layer 174.

The first common source layer 172 may include a first portion 172a. The first portion 172a may be electrically connected to the channel expanded portion CHb of the channel structure CH on the first surface 120a of the gate stacking structure 120 exposed by the opening 168p. The first common source layer 172 may further include a second portion 172b and/or a third portion 172c. The second portion 172b may be disposed on the side surface of the cover insulation layer 168a in which the opening 168p is disposed. The third portion 172c may be disposed on an outer surface of the cover insulation layer 168a.

For example, the first portion 172a of the first common source layer 172 may be in contact with the first surface 120a of the gate stacking structure 120 and the channel expanded portion CHb of the channel structure CH. The second portion 172b of the first common source layer 172 may be in contact with the side surface (e.g., the rounded portion or the concave shape) of the cover insulation layer 168a, and the third portion 172c of the first common source layer 172 may be in contact with the outer surface of the cover insulation layer 168a.

When the first common source layer 172 is in contact with the first surface 120a of the gate stacking structure 120, the channel expanded portion CHb of the channel structure CH, and/or the cover insulation layer 168a, the channel structure CH and the common source layer 170 may be electrically connected to each other by an easy process. However, the embodiments are not limited thereto. In some embodiments, the first common source layer 172 may not be in contact with the first surface 120a of the gate stacking structure 120, the channel expanded portion CHb of the channel structure CH, and/or the cover insulation layer 168a, and another layer may be further provided.

The first portion 172a of the first common source layer 172 may include a horizontal conductive portion 1721a, 1722a, and 1723a. The horizontal conductive portion 1721a, 1722a, and 1723a may be disposed on the first surface 120a of the gate stacking structure 120 and the channel expanded portion CHb of the channel structure CH exposed by the opening 168p. The horizontal conductive portion 1721a, 1722a, and 1723a may include a first horizontal portion 1721a, a second horizontal portion 1722a, and a third horizontal portion 1723a. The first horizontal portion 1721a may be disposed on a first surface (an upper surface in FIG. 6) of the channel expanded portion CHb opposite to or spaced apart from the gate stacking structure 120. The second horizontal portion 1722a may be disposed on a side surface of the channel expanded portion CHb. The third horizontal portion 1723a may be disposed at a periphery of the channel expanded portion CHb on the first surface 120a of the gate stacking structure 120.

The horizontal conductive portion 1721a, 1722a, and 1723a (e.g., the first and second horizontal portions 1721a and 1722a) may be in contact with the channel expanded portion CHb. For example, the horizontal conductive portion 1721a, 1722a, and 1723a may be in contact with the core insulation layer 142 in the channel expanded portion CHb. However, the embodiments are not limited thereto.

In a cross-sectional view, the first horizontal portion 1721a and the second horizontal portion 1722a may be connected to have an obtuse angle (e.g., an angle greater than 90 degrees and less than 180 degrees). In a cross-sectional view, the second horizontal portion 1722a and the third horizontal portion 1723a may be connected to have an obtuse angle (e.g., an angle greater than 90 degrees and less than 180 degrees).

In FIG. 6, it is illustrated as an example that a thickness T1 of the first horizontal portion 1721a, a thickness T2 of the second horizontal portion 1722a, and a thickness T3 of the third horizontal portion 1723a are substantially same. Substantially same may refer to have a difference within a process error (e.g., less than 10%). However, the embodiments are not limited thereto, and at least two of the thickness T1 of the first horizontal portion 1721a, the thickness T2 of the second horizontal portion 1722a, and the thickness T3 of the third horizontal portion 1723a may be different from each other.

The first portion 172a of the first common source layer 172 may further include an extending conductive portion 1724a and 1725a. The extending conductive portion 1724a and 1725a may include a portion between the gate stacking structure 120 and at least a portion of the channel structure CH. For example, the first portion 172a of the first common source layer 172 or the extending conductive portion 1724a and 1725a may include a first extending portion 1724a and a second extending portion 1725a. The first extending portion 1724a may be disposed between a second surface (a lower surface in FIG. 6) of the channel expanded portion CHb adjacent to the first surface 120a of the gate stacking structure 120 and the second dielectric portion 150b. The second extending portion 1725a may extend from the first extending portion 1724a and may be disposed on the first dielectric portion 150a at a side surface of the channel penetration portion CHa. For example, the first extending portion 1724a may be disposed between the first surface 120a of the gate stacking structure 120 and the second surface of the channel expanded portion CHb. For example, the second extending portion 1725a may be disposed between the gate dielectric layer 150 and the core insulation layer 142 at the side surface of the channel penetration portion CHa.

For example, the first extending portion 1724a may be in contact with the second surface of the channel expanded portion CHb (e.g., the core insulation layer 142) and/or the first surface 120a of the gate stacking structure 120. The second extending portion 1725a may be in contact with a side surface of the gate dielectric layer 150 and/or a side surface of the core insulation layer 142 in the channel penetration portion CHa. However, the embodiments are not limited thereto.

For example, in the extension direction of the channel structure CH (the Z-axis direction in the drawings), the second extending portion 1725a may not overlap the gate electrode 130, or may overlap one or two gate electrodes 130. Thereby, unwanted effect that may be induced by the second extending portion 1725a on an operation of a transistor including the gate electrode 130 may be reduced. For example, in the extension direction of the channel structure CH, the second extending portion 1725a may be disposed to correspond to an inside of an outermost interlayer insulation layer 132n at the first surface 120a of the gate stacking structure 120. Thereby, unwanted effect that may be induced by the second extending portion 1725a on an operation of a transistor including the gate electrode 130 may be minimized. However, the embodiments are not limited thereto, and the second extending portion 1725a may be disposed to overlap three or more gate electrodes 130 in the extension direction of the channel structure CH.

The first extending portion 1724a may extend to be parallel to the third horizontal portion 1723a. A thickness T4 of the first extending portion 1724a may be less than the thickness T1 of the first horizontal portion 1721a, the thickness T2 of the second horizontal portion 1722a, or the thickness T3 of the third horizontal portion 1723a. In a cross-sectional view, the first extending portion 1724a and the second extending portion 1725a may be connected to have an obtuse angle (e.g., an angle greater than 90 degrees and less than 180 degrees) or a right angle. In a cross-sectional view, an angle between the first extending portion 1724a and the second extending portion 1725a may be less than an angle between the first horizontal portion 1721a and the second horizontal portion 1722a or an angle between the second horizontal portion 1722a and the third horizontal portion 1723a. A thickness T5 of the second extending portion 1725a may be less than the thickness T1 of the first horizontal portion 1721a, the thickness T2 of the second horizontal portion 1722a, or the thickness T3 of the third horizontal portion 1723a.

The second portion 172b of the first common source layer 172 may be in contact with the side surface of the cover insulation layer 168a in which the opening 168p is disposed. In an embodiment, by using the opening 168p of the cover insulation layer 168a, a portion of the cell array region 102 in which the first portion 172a of the first common source layer 172 is disposed and another portion (e.g., the connection region 104, the buffer region 106, and the outer region 12) may be separated. Thereby, an additional regional separation pattern configured to separate to a portion of the cell array region 102 and another portion may not be included, and a structure and a manufacturing process may be simplified.

On the other hand, in a comparative example including an additional regional separation pattern configured to separate to a portion of a cell array region and another portion, a photolithography process, an etching process, a deposition process (e.g., ab atomic layer deposition (ALD) process), a chemical mechanical polishing process, or the like may be additionally performed. Accordingly, a manufacturing process may be complicated. Particularly, the regional separation pattern may be formed to have a fine pattern between a plurality of channel structures or between a channel structure and a dummy structure having a small interval, and a manufacturing process may be complicated and/or a new process or facility may be applied.

In an embodiment, the second common source layer 174 may include a first portion on the first portion 172a of the first common source layer 172. The second common source layer 174 may include a second portion on the second portion 172b of the first common source layer 172 and/or a third portion on the third portion 172c of the first common source layer 172.

For example, the first portion of the second common source layer 174 may be in contact with the first portion 172a of the first common source layer 172, the second portion of the second common source layer 174 may be in contact with the second portion 172b of the first common source layer 172, and/or the third portion of the second common source layer 174 may be in contact with the third portion 172c of the first common source layer 172. However, the embodiments are not limited thereto. In some embodiments, the second common source layer 174 may not be in contact with the first common source layer 172, and an additional layer may be provided between the first common source layer 172 and the second common source layer 174. In some embodiments, the second common source layer 174 may be omitted.

The common source layer 170 may cover the entirety of the opening 168p of the cover insulation layer 168a, and may be disposed on a portion of the cover insulation layer 168a. In a plan view, an inner portion of the common source layer 170 may overlap the opening 168p and an edge portion of the common source layer 170 may overlap the cover insulation layer 168a to have a rectangular shape, but the embodiments are not limited thereto.

The channel layer 140 may be connected to (e.g., in contact with) an end of the extending conductive portion 1724a and 1725a (e.g., the second extending portion 1725a) in the channel penetration portion CHa. The extending conductive portion 1724a and 1725a may fill a portion in which the portion of the channel layer 140 is removed. For example, a portion of the channel layer 140 surrounding the channel expanded portion CHb (e.g., a portion of the channel layer 140 on a first surface (an upper surface in FIG. 6), a side surface, and a second surface (a lower surface in FIG. 6) of the channel expanded portion CHb) may be removed, and the first common source layer 172 may be formed. Accordingly, the first common source layer 172 may include the extending conductive portion 1724a and 1725a.

The length of the channel extending portion CHc or the thickness T4 or T5 of the extending conductive portion 1724a or 1725a may be substantially same as the thickness T0 of the channel layer 140. For example, the length of the channel extending portion CHc or the thickness T4 or T5 of the extending conductive portion 1724a or 1725a may be in a range of 90% to 110% of the thickness T0 of the channel layer 140. However, the embodiments are not limited thereto. In some embodiments, if the extending conductive portion 1724a and 1725a may be disposed in a portion in which the portion of the channel layer 140 is removed, the length of the channel extending portion CHc and the thickness of the channel layer 140 may be different from each other.

In the side surface of the channel penetration portion CHa, the channel layer 140 may include a diffusion doping portion 140d at a portion adjacent to the first common source layer 172 (e.g., the second extending portion 1725a). The diffusion doping portion 140d of the channel layer 140 may have a conductive type same as a conductive type of the first common source layer 172, and may have a doping concentration greater than a doping concentration of an undoped portion 140u of the channel layer 140.

As illustrated in FIG. 7, the first common source layer 172 may have a substantially same or uniform doping concentration. For example, the first portion 172a of the first common source layer 172 (e.g., the horizontal conductive portion 1721a, 1722a, and 1723a, and the extending conductive portion 1724a and 1725a), the second portion 172b, and the third portion 172c may have a substantially same or uniform doping concentration. Substantially same may refer to have a difference within a process error (e.g., less than 10%). The doping concentration of the diffusion doping portion 140d may gradually decrease far away from the first common source layer 172. This may be because the diffusion doping portion 140d is formed by a diffusion of a dopant included in the first common source layer 172 to a portion of the channel layer 140.

By the doping concentration, a position of the diffusion doping portion 140d, and a boundary between the diffusion doping portion 140d and the first common source layer 172 may be confirmed or expected.

In an embodiment, in the channel structure CH including the channel expanded portion CHb, a horizontal doping region a sidewall doping region may be included. The horizontal doping region may be disposed between the second dielectric portion 150b (or the first surface 120a of the gate stacking structure 120) and the second surface (the lower surface in FIG. 6) of the channel expanded portion CHb. The sidewall doping region may be disposed on the first dielectric portion 150a at the side surface of the channel penetration portion CHa. In the extension direction of the channel structure CH (the Z-axis direction in the drawings), the sidewall doping region may include a portion overlapping the second dielectric portion 150b that extends in the horizontal direction. For example, the sidewall doping region may be disposed between the first dielectric portion 150a and the core insulation layer 142 at the side surface of the channel penetration portion CHa.

The horizontal doping region may be or include a portion of the common source layer 170. For example, the horizontal doping region may include at least a portion (e.g., the first extending portion 1724a) of the extending conductive portion 1724a and 1725a. The sidewall doping region may include a portion of the common source layer 170 (e.g., at least a portion (e.g., the second extending portion 1725a) of the extending conductive portion 1724a and 1725a) that is disposed between the first dielectric portion 150a and the core insulation layer 142, and/or the diffusion doping portion 140d of the channel layer 140.

As in the above, the common source layer 170 (e.g., the first portion 172a of the first common source layer 172 or the doped semiconductor layer) may surround the entirety of the surface (e.g., the first surface, the side surface, and the second surface) of the channel expanded portion CHb. That is, the horizontal doping region and the sidewall doping region having a dopant to have a low electrical resistance may be disposed at a corner portion (e.g., an L-shaped portion) of the channel expanded portion CHb. Accordingly, a cell current at the corner portion (e.g., the L-shaped portion) of the channel expanded portion CHb may be improved.

In an embodiment, the first common source layer 172 (e.g., the extending conductive portion 1724a and 1725a) may be formed in a portion in which a portion of the channel layer 140 in the channel expanded portion CHb is removed. Thus, a doping region having a high doping concentration may be formed at the corner portion of the channel expanded portion CHb without performing an additional doping process and/or an additional annealing process to increase a doping concentration of the channel layer 140. Thereby, a manufacturing process may be performed without a new facility or a new process (e.g., an ion implantation process) and may be simplified. In the process of removing the portion of the channel layer 140 of the channel expanded portion CHb, a particle at a periphery of the channel expanded portion CHb may be removed and a defect may be reduced.

In an embodiment, the sidewall doping region may include the second extending portion 1725a and the diffusion doping portion 140d together, and the sidewall doping region may have a sufficient length or area. That is, by including the second extending portion 1725a extending along the channel penetration portion CHa, the diffusion doping portion 140d may be formed by a dopant diffused from the second extending portion 1725a and the sidewall doping region may have the sufficient length or area. Thereby, the cell current may be effectively improved. However, the embodiments are not limited thereto, and the sidewall doping region may include at least one of the second extending portion 1725a and the diffusion doping portion 140d.

On the other hand, in a comparative example that a common source layer including a dopant is formed on a channel layer, the dopant may be diffused to a portion of the channel layer in a channel expanded portion. Accordingly, a portion of the channel layer at an outer surface of the channel expanded portion may include a doping diffusion region in which doping concentration gradually decreases. In this instance, the dopant may not be sufficiently diffused to a portion of the channel layer at a corner portion of the channel expanded portion, and an undoped portion may be disposed at the corner portion of the channel expanded portion. Thereby, a cell current at the corner portion of the channel expanded portion may not be sufficient.

In an embodiment, a thickness of the cover insulation layer 168a may be greater than the thickness of the first common source layer 172 or a height of the channel expanded portion CHb. The thickness of the cover insulation layer 168a may be a thickness (e.g., a maximum thickness) in the extension direction of the channel structure CH (the Z-axis direction in the drawings). The thickness of the first common source layer 172 may be a thickness (e.g., a maximum thickness) perpendicular to a extension direction of the first common source layer 172. For example, the thickness of the first common source layer 172 may be a maximum thickness of the thickness T1 of the first horizontal portion 1721a, the thickness T2 of the second horizontal portion 1722a, and the thickness T3 of the third horizontal portion 1723a. The height of the channel expanded portion CHb may be a length or a thickness (e.g., a maximum length or a maximum thickness) in the extension direction of the channel structure CH. Thereby, the cover insulation layer 168a may stably protect the connection region 104, the buffer region 106, and/or the outer region 12. However, the embodiments are not limited thereto.

In an embodiment, the thickness of the first common source layer 172 may be less than the height of the channel expanded portion CHb. For example, in the extension direction of the channel structure CH (the Z-axis direction in the drawings), a first surface (an upper surface in FIG. 6) of the third horizontal portion 1723a may be lower than the first surface (the upper surface in FIG. 6) of the channel expanded portion CHb. For example, in the extension direction of the channel structure CH, the first surface of the third horizontal portion 1723a may be between the first surface (the upper surface in FIG. 6) and the second surface (the lower surface in FIG. 6) of the channel expanded portion CHb. When the thickness of the first common source layer 172 is relatively small, energy used in a heat treatment process of the first common source layer 172 may be reduced. However, the embodiments are not limited thereto, and the thickness of the first common source layer 172 may be same as or greater than the height of the channel expanded portion CHb.

A thickness T6 of the second common source layer 174 (e.g., a maximum thickness) may be less than a thickness (e.g., a maximum thickness) of the first common source layer 172. However, the embodiments are not limited thereto, and the thickness T6 of the second common source layer 174 may be same as or greater than the thickness of the first common source layer 172.

In an embodiment, in the extension direction of the channel structure CH (the Z-axis direction in the drawings), a length D1 of the second extending portion 1725a, a length D2 of the diffusion doping portion 140d, or a length of the sidewall doping region may be greater than the thickness T4 of the first extending portion 1724a or the thickness of the horizontal doping region. The length D1 of the second extending portion 1725a may refer to a length (e.g., a maximum length) from the first surface 150h of the second dielectric portion 150b. The first surface 150h of the second dielectric portion 150b may refer to a surface adjacent to the first surface 120a of the gate stacking structure 120. Thereby, the length D1 of the second extending portion 1725a may be sufficient, and the cell current may be effectively improved.

In an embodiment, in the extension direction of the channel structure CH (the Z-axis direction in the drawings), the length D1 of the second extending portion 1725a may be less than the thickness (e.g., the maximum thickness) of the first common source layer 172. For example, the length D1 of the second extending portion 1725a may be less than the thickness of the first common source layer 172 (e.g., the thickness T1 of the first horizontal portion 1721a, the thickness T2 of the second horizontal portion 1722a, or the thickness T3 of the third horizontal portion 1723a). Thereby, the second extending portion 1725a may be stably formed. However, the embodiments are not limited thereto. The length D1 of the second extending portion 1725a may be same as or greater than the thickness of the first common source layer 172. Thereby, the length D1 of the second extending portion 1725a may be sufficient to improve the cell current at the corner portion of the channel expanded portion CHb.

In an embodiment, in the extension direction of the channel structure CH (the Z-axis direction in the drawings), the length D2 of the diffusion doping portion 140d may be less than the thickness (e.g., the maximum thickness) of the first common source layer 172. Thereby, unwanted effect that may be induced by the diffusion doping portion 140d on an operation of a transistor including the gate electrode 130 may be minimized. However, the embodiments are not limited thereto. In some embodiments, the length D2 of the diffusion doping portion 140d may be same or greater than the thickness (e.g., the maximum thickness) of the first common source layer 172.

In an embodiment, in the extension direction of the channel structure CH (the Z-axis direction in the drawings), the length D1 of the second extending portion 1725a may be greater than the length D2 of the diffusion doping portion 140d. The length D2 of the diffusion doping portion 140d may refer to a length (e.g., a maximum length) from a portion adjacent to the second extending portion 1725a. In some embodiments, the length D1 of the second extending portion 1725a may be same as or less than the length D2 of the diffusion doping portion 140d.

In an embodiment, in the extension direction of the channel structure CH (the Z-axis direction in the drawings), the length D1 of the second extending portion 1725a or the length D2 of the diffusion doping portion 140d may be less than the height of the channel expanded portion CHb. Thereby, the second extending portion 1725a may be stably formed, and unwanted effect that may be induced by the second extending portion 1725a or the diffusion doping portion 140d on an operation of a transistor including the gate electrode 130 may be minimized. However, the embodiments are not limited thereto, and the length D1 of the second extending portion 1725a or the length D2 of the diffusion doping portion 140d may be same as or greater than the height of the channel expanded portion CHb.

According to an embodiment, the cover insulation layer 168a having the opening 168p may be included, and a structure selectively exposing at least a portion of the cell array region 102 may be easily formed. The entirety of the side surface of the channel penetration portion CHa and/or the channel extending portion CHc may be surrounded by the gate dielectric layer 150, and a structural stability of the channel structure CH including the channel expanded portion CHb may be improved. The common source layer 170 may be formed in an empty space formed by removing a portion of the channel layer 140 adjacent to the channel expanded portion CHb, and the cell current at the corner portion of the channel expanded portion CHb may be improved and a particle may be removed. Thereby, productivity and reliability of the semiconductor device 10 may be improved.

In the description, it is described as an example that the semiconductor device 10 is the bonding vertical NAND flash memory. However, the embodiments are not limited thereto, and the embodiments may be applied to any of various semiconductor devices or various bonding semiconductor devices.

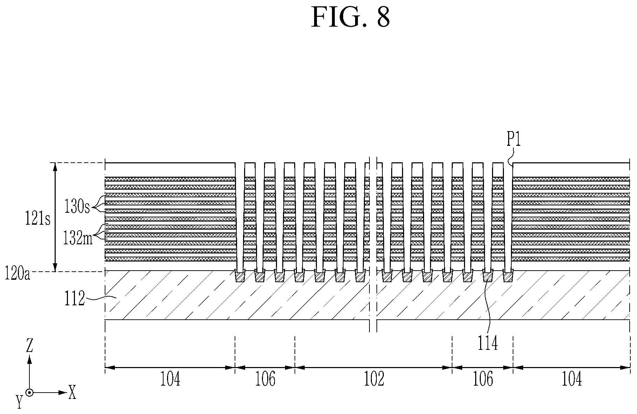

FIG. 8 to FIG. 19 are cross-sectional views illustrating a manufacturing method of a semiconductor device according to an embodiment. Hereinafter, a manufacturing method of a semiconductor device will be described based on a gate stacking structure 120, a channel structure CH, a separation structure 146 (refer to FIG. 2), a cover insulation layer 168a, and a common source layer 170 that are included in a cell region. FIG. 8 to FIG. 14, and FIG. 17 to FIG. 19 illustrate a portion corresponding to FIG. 5, and FIG. 15 and FIG. 16 illustrate a portion corresponding to FIG. 6.

As illustrated in FIG. 8, an etch stopping pattern 114 may be formed in a semiconductor substrate 112, a first stacking portion 121s may be formed on the semiconductor substrate 112, and a first preliminary penetration part P1 passing through the first stacking portion 121s may be formed.

The semiconductor substrate 112 may include a semiconductor material. For example, the semiconductor substrate 112 may be a semiconductor substrate including or being formed of a semiconductor material or may be a semiconductor substrate in which a semiconductor layer is on a base substrate. For example, the semiconductor substrate 112 may include or be formed of a semiconductor material (e.g., silicon, germanium, silicon-germanium, or the like) having a single-crystalline, epitaxial, or polycrystalline structure, silicon on insulator (SOI), germanium on insulator (GOI), or the like.

The etch stopping pattern 114 may be formed in the semiconductor substrate 112. The etch stopping pattern 114 may be formed in a portion where the first preliminary penetration part P1 will be formed in a plan view. The etch stopping pattern 114 may have a shape corresponding to a shape of the first preliminary penetration part P1, and may have a width or an area greater than a width or an area of the first preliminary penetration part P1.

The etch stopping pattern 114 may include or be formed of at least one of a semiconductor material (e.g., polycrystalline silicon), metal (e.g., tungsten), metal nitride (e.g., tungsten nitride or titanium nitride), and carbon. The etch stopping pattern 114 may include a single layer or a plurality of layers. In an embodiment, an interface layer including an insulating material may be further included between the semiconductor substrate 112 and the etch stopping pattern 114.

The etch stopping pattern 114 may be formed by forming a trench where the etch stopping pattern 114 will be disposed in the semiconductor substrate 112 using a mask layer and thereafter filling a filling material in the trench. The process of forming the trench may be performed by any of various processes (e.g., an etching process or the like), and the process of filling the filling material may be performed by any of various processes (e.g., a deposition process or the like).

In an embodiment, an upper insulation layer may be further formed on the semiconductor substrate 112. For example, the upper insulation layer may be formed of a remained portion of the mask layer for forming the etch stopping pattern 114. When the upper insulation layer may include a material same as a material of an interlayer insulation layer 132m of the first stacking portion 121s, a boundary between the upper insulation layer and the interlayer insulation layer 132m may not be confirmed. In this instance, an upper surface of the etch stopping pattern 114 may protrude from an upper surface of the semiconductor substrate 112, as illustrated in FIG. 8. Other various modified embodiments are possible.

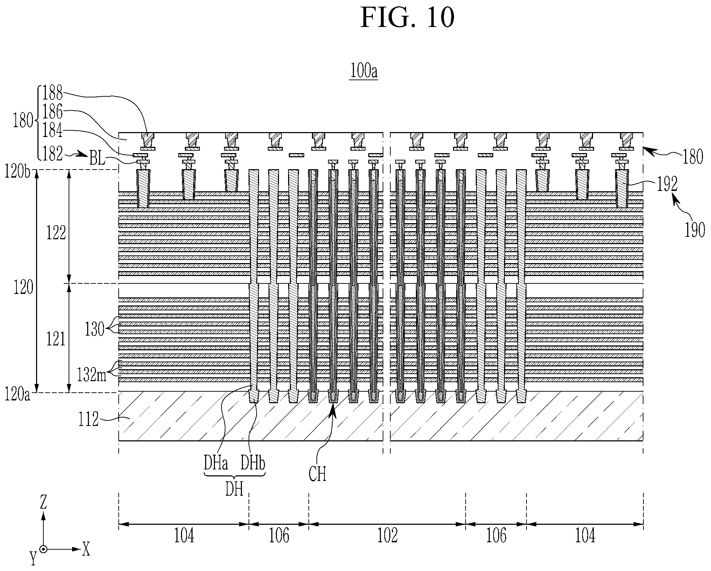

The first stacking portion 121s may be formed on the semiconductor substrate 112. For example, the first stacking portion 121s may be formed by alternately stacking interlayer insulation layers 132m and sacrificial insulation layers 130s on the semiconductor substrate 112. At least a portion of the sacrificial insulation layer 130s may be replaced with a gate electrode 130 (refer to FIG. 10) through a subsequent process. The sacrificial insulation layer 130s may be formed to correspond to a portion in which the gate electrode 130 will be disposed.

The sacrificial insulation layer 130s may include a material different from a material of the interlayer insulation layer 132m. For example, the interlayer insulation layer 132m may include or be formed of at least one of silicon oxide, silicon nitride, silicon oxynitride, a low dielectric constant material, or the like. The sacrificial insulation layer 130s may include or be formed of at least one of silicon, silicon oxide, silicon carbide, and silicon nitride, and may include a material different from a material of the interlayer insulation layer 132m.

The interlayer insulation layer 132m or the sacrificial insulation layer 130s may be formed by any of various processes (e.g., a deposition process or the like).

The first preliminary penetration part P1 passing through the first stacking portion 121s may be formed. The first preliminary penetration part P1 may be formed by any of various processes (e.g., an etching process or the like).

An end of the first preliminary penetration part P1 adjacent to the semiconductor substrate 112 may be disposed in the etch stopping pattern 114. Since the etch stopping pattern 114 may have a width or an area greater than a width or an area of the first preliminary penetration part P1, the entirety of the end of the first preliminary penetration part P1 may be stably disposed in the etch stopping pattern 114.

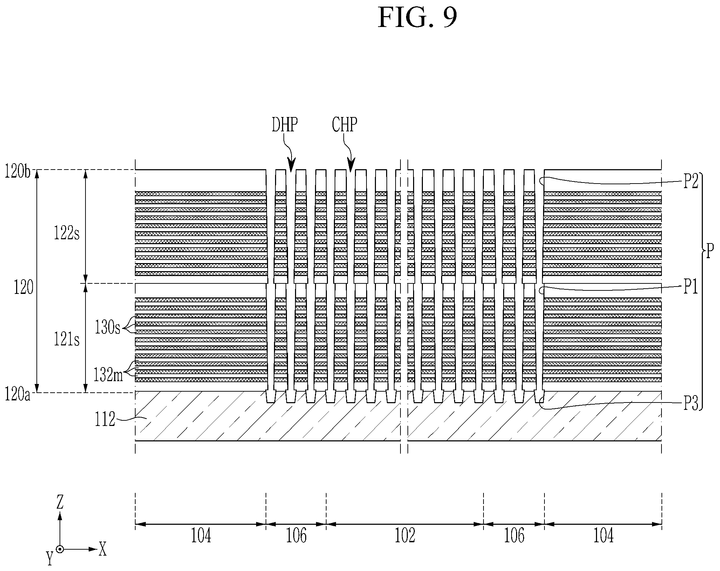

Subsequently, as illustrated in FIG. 9, an insulation stacking structure 120s may be formed by forming a second stacking portion 122s, and a preliminary penetration part P may be formed.

For example, a sacrificial portion may be formed by filling a sacrificial material in the first preliminary penetration part P1, the second stacking portion 122s may be formed, a second preliminary penetration part P2 passing through the second stacking portion 122s may be formed, and the sacrificial portion and the etch stopping pattern 114 (refer to FIG. 8) may be removed. A portion where the etch stopping pattern 114 was disposed may constitute an expanded penetration part P3. Thereby, the preliminary penetration part P including the first preliminary penetration part P1, the second preliminary penetration part P2, and the expanded penetration part P3 may be formed.

The sacrificial portion in the first preliminary penetration part P1 may include or be formed of at least one of a semiconductor material (e.g., polycrystalline silicon), metal (e.g., tungsten), metal nitride (e.g., tungsten nitride or titanium nitride), and carbon. For example, the sacrificial portion may include a material same as or different from a material of the etch stopping pattern 114.

The description of the sacrificial insulation layer 130s and/or the interlayer insulation layer 132m of the first stacking portion 121s may be applied to the sacrificial insulation layer 130s and/or the interlayer insulation layer 132m of the second stacking portion 122s. The second preliminary penetration part P2 may be formed by any of various processes (e.g., an etching process or the like). The process of removing the sacrificial portion and the etch stopping pattern 114 may be performed by any of various processes (e.g., an etching process or the like).

In an embodiment, it is illustrated and described as an example that the insulation stacking structure 120s includes the first stacking portion 121s and the second stacking portion 122s sequentially stacked on the semiconductor substrate 112. However, the embodiments are not limited thereto, and the insulation stacking structure 120s may include a single stacking portion or three or more stacking portions.

In an embodiment, the preliminary penetration part P may include a channel preliminary penetration part CHP where a channel structure CH (refer to FIG. 10) will be disposed. The preliminary penetration part P may further include a dummy preliminary penetration part DHP in which a dummy structure DH (refer to FIG. 10) will be disposed, a separation preliminary penetration part in which at least a portion of a separation structure 146 (refer to FIG. 2) will be disposed, and/or a wiring preliminary penetration part in which an input/output connection wiring 194 (refer to FIG. 2) will be disposed.

As described in the above, the etch stopping pattern 114 is disposed to correspond to the portion where the preliminary penetration part P will be disposed, and the preliminary penetration part P may include the expanded penetration part P3 formed by removing the etch stopping pattern 114. Accordingly, in an embodiment, each of the channel preliminary penetration part, the dummy preliminary penetration part, the separation preliminary penetration part, and/or the wiring preliminary penetration part may include the expanded penetration part P3.

First and second preliminary penetration parts P1 and P2 of the preliminary penetration part P corresponding to the channel structure CH, the dummy structure DH, or the input/output connection wiring may have a shape corresponding to a shape of a channel penetration portion of the channel structure CH, a dummy penetration portion of the dummy structure DH, or a wiring penetration portion of the input/output connection wiring. An expanded penetration part P3 of the preliminary penetration part P corresponding to the channel structure CH, the dummy structure DH, or the input/output connection wiring may have a shape corresponding to a shape of a channel expanded portion of the channel structure CH, a dummy expanded portion of the dummy structure DH, or a wiring expanded portion of the input/output connection wiring. For example, the expanded penetration part P3 of the preliminary penetration part P corresponding to the channel structure CH, the dummy structure DH, or the input/output connection wiring may have any of various planar shapes (e.g., a circular shape, an oval shape, a polygonal shape, or the like) corresponding to the channel expanded portion of the channel structure CH, the dummy expanded portion of the dummy structure DH, or the wiring expanded portion of the input/output connection wiring. For example, the expanded penetration part P3 of the preliminary penetration part P corresponding to the channel structure CH, the dummy structure DH, or the input/output connection wiring may have a width or an area greater than a width or an area of each of the first and second preliminary penetration parts P1 and P2 of the preliminary penetration part P corresponding to the channel structure CH, the dummy structure DH, or the input/output connection wiring.

First and second preliminary penetration parts P1 and P2 of the preliminary penetration part P corresponding to the separation structure may correspond to a portion of the separation structure. For example, the first and second preliminary penetration parts P1 and P2 of the preliminary penetration part P corresponding to the separation structure may have any of various planar shapes (e.g., a circular shape, an oval shape, a polygonal shape, or the like). For example, an expanded penetration part P3 of the preliminary penetration part P corresponding to the separation structure may have a width or an area greater than a width or an area of each of the first and second preliminary penetration parts P1 and P2 of the preliminary penetration part P corresponding to the separation structure.

In an embodiment, it is described and illustrated as an example that the preliminary penetration part P does not include a preliminary penetration part corresponding to a gate contact 192 (refer to FIG. 10), but the preliminary penetration part P may include a preliminary penetration part corresponding to the gate contact 192.

Subsequently, as illustrated in FIG. 10, a preliminary cell region 100a may be formed by forming a gate stacking structure 120 and forming a channel structure CH, a dummy structure DH, a separation structure, a penetration wiring portion 190, and a second wiring portion 180.

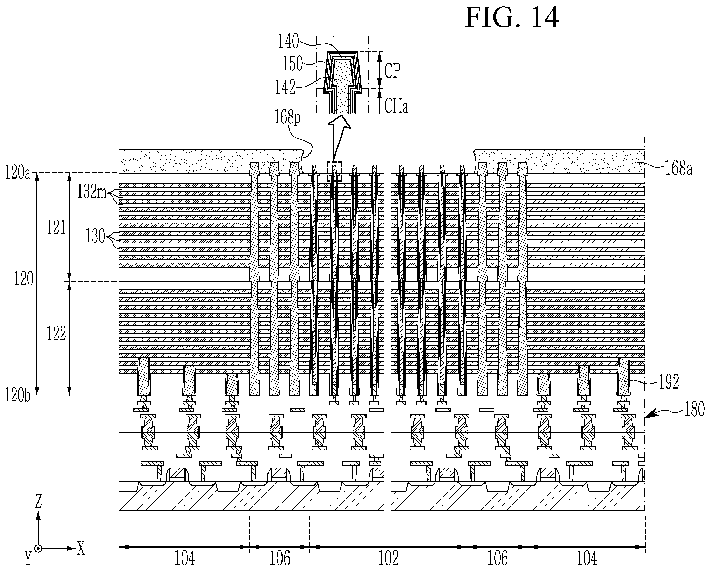

The channel structure CH may be formed in the channel preliminary penetration part CHP (refer to FIG. 9). For example, a gate dielectric layer 150 (refer to FIG. 14), a channel layer 140 (refer to FIG. 14), and a core insulation layer 142 (refer to FIG. 14 142 ) may be sequentially formed in the channel preliminary penetration part CHP. In this instance, a first blocking layer 156a (refer to FIG. 3) of the gate dielectric layer 150 may not be formed, and may be formed in a subsequent process. The process of forming the gate dielectric layer 150, the channel layer 140, or the core insulation layer 142 may be performed by any of various processes (e.g., a deposition process or the like).

The dummy structure DH may be formed in the dummy preliminary penetration part DHP (refer to FIG. 9). For example, the dummy structure DH may be formed by filling an insulating material or the like in the dummy preliminary penetration part DHP, or the dummy structure DH may be formed by filling a layer included in the channel structure CH in the dummy preliminary penetration part DHP. A portion of the dummy structure DH may be formed by using the sacrificial material or the like in the dummy preliminary penetration part DHP. Other various modified embodiments are possible.

A penetration part for the separation structure may be formed by performing an etching process of expanding the preliminary penetration part P corresponding to the separation structure in a horizontal direction. Thereby, a side surface of the penetration part for the separation structure may have a shape in which curved surfaces of a convex curvature outward are disposed continuously as illustrated in FIG. 4. However, the embodiments are not limited thereto. In some embodiments, the preliminary penetration part P corresponding to the separation structure may not be formed, and the penetration part for the separation structure may be formed after the insulation stacking structure 120s is formed. Other various modified embodiments are possible.

A gate contact 192 may be formed in a connection region 104, and an input/output connection wiring may be formed in an outer region. The gate contact 192 and/or the input/output connection wiring may be formed by any of various processes, but the embodiments are not limited thereto.

The sacrificial insulation layer 130s (refer to FIG. 9) may be replaced with a gate electrode 130 by using the penetration part for the separation structure, and a separation structure may be formed by filling a filling material in the penetration part for the separation structure. A separation pattern 148 (refer to FIG. 2) may be formed, and the second wiring portion 180 may be formed.

For example, the sacrificial insulation layer 130s may be selectively removed by using an etching process (e.g., a wet etching process) through the penetration part for the separation structure. A conductive material may be formed or filled in a portion where the sacrificial insulation layer 130s was removed. The process of forming the gate electrode 130 may be performed by any of various processes (e.g., a deposition process or the like). Thereby, a horizontal region where the sacrificial insulation layer 130s was disposed may be replaced with the gate electrode 130. In this instance, a process of forming a first blocking layer 156a (refer to FIG. 3) may be further performed before the process of filing the conductive material constituting the gate electrodes 130.

Thereby, the gate stacking structure 120 including a gate electrode 130 and an interlayer insulation layer 132m may be formed. In an embodiment, the gate stacking structure 120 may include a plurality of gate stacking portions 121 and 122 sequentially stacked on the semiconductor substrate 112. However, the embodiments are not limited thereto.

The process of filling the filling material in the penetration part for the separation structure may be performed by any of various processes (e.g., a deposition process or the like). For example, an insulation layer may be formed to fill the penetration part for the separation structure. The separation structure may include a penetration portion and an expanded portion having a width or an area less than a width or an area of the penetration portion.

The separation pattern may be formed in a portion of the insulation stacking structure 120s (refer to FIG. 9) or the gate stacking structure 120. The separation pattern may be formed by forming an opening for the separation pattern through an etching process using a mask layer and filling an insulating material in at least a portion of the opening for the separation pattern. In a manufacturing method of a semiconductor device, a process of forming the separation pattern may be variously modified.

A second wiring portion 180 including a second wiring layer 182 including a bit line BL, a second contact 184, an insulation layer 186, and a bonding structure 188 may be formed. Thereby, the preliminary cell region 100a may be formed.

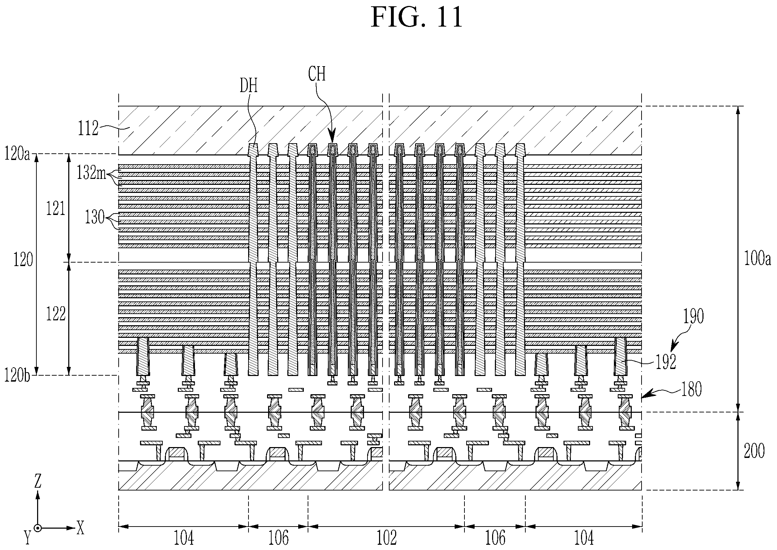

Subsequently, as illustrated in FIG. 11, the preliminary cell region 100a may be bonded to a circuit region 200. For example, on the circuit region 200, the preliminary cell region 100a may be bonded to have a reversed structure. In the reversed structure, a portion of the preliminary cell region 100a far away from the semiconductor substrate 112 may be disposed to face the circuit region 200. Hybrid bonding may be performed through an annealing process in a state that the circuit region 200 and the preliminary cell region 100a are in contact with each other.

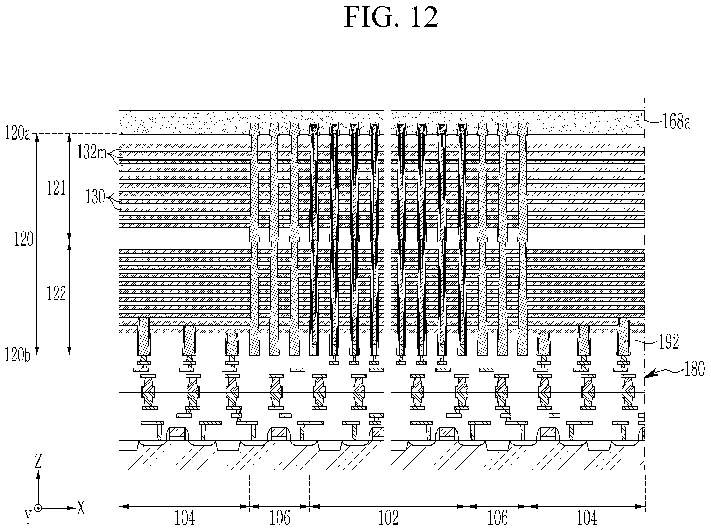

Subsequently, as illustrated in FIG. 12, the semiconductor substrate 112 (refer to FIG. 11) may be removed, and a cover insulation layer 168a may be formed on a first surface 120a of the gate stacking structure 120.

The process of removing the semiconductor substrate 112 may be performed by any of various processes (an etching process, a grinding process, a chemical mechanical polishing process, or the like). When the semiconductor substrate 112 is removed, the first surface 120a of the gate stacking structure 120 and a portion of the channel structure CH on the first surface 120a of the gate stacking structure 120 may be exposed.

In the process of forming the cover insulation layer 168a, the cover insulation layer 168a may be entirely formed on the first surface 120a of the gate stacking structure 120 and the channel structure CH. The cover insulation layer 168a may be formed by any of various processes. For example, the cover insulation layer 168a may be formed by a deposition process, as an example, a plasma enhanced chemical vapor deposition (PECVD) or the like.

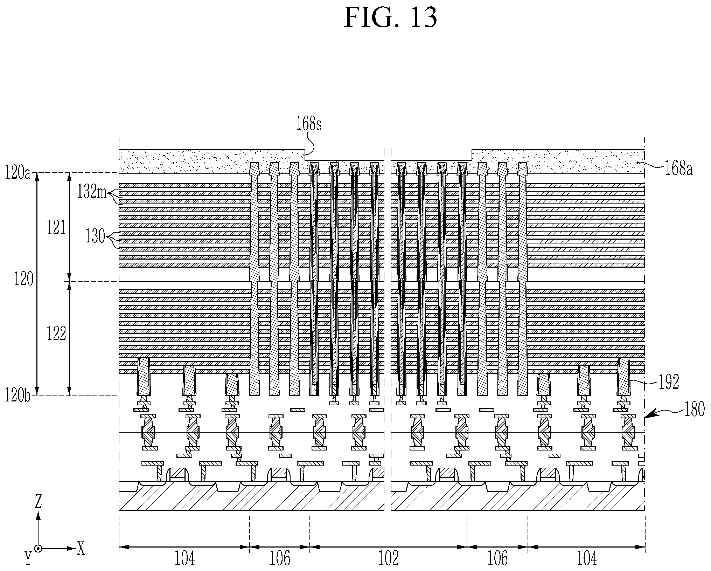

Subsequently, as illustrated in FIG. 13 and FIG. 14, an opening 168p may be formed in the cover insulation layer 168a. The opening 168p of the cover insulation layer 168a may be disposed to expose at least a portion of a cell array region 102. Thereby, a region (e.g., a connection region 104, a buffer region 106, and/or an outer region) other than the cell array region 102 may be protected by the cover insulation layer 168a, and at least a portion of the cell array region 102 may be exposed by the opening 168p.

For example, the opening 168p may be formed by forming a portion (e.g., an opening portion 168s) of the opening 168p by using a first etching process as illustrated in FIG. 13 and forming another portion of the opening 168p by using a second etching process different from the first etching process as illustrated in FIG. 14,

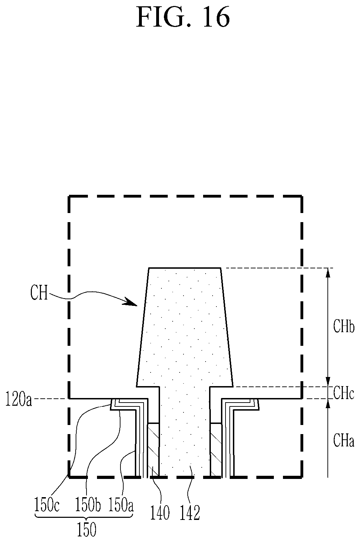

In the first etching process illustrated in FIG. 13, the opening portion 168s may be formed by removing a portion of the cover insulation layer 168a in a thickness direction of the cover insulation layer 168a (a Z-axis direction in the drawing). The opening portion 168s may be formed not to expose a protrusion portion CP (refer to FIG. 14) of the channel structure CH protrude from the first surface 120a of the gate stacking structure 120. That is, the cover insulation layer 168a may be disposed under the opening portion 168s to cover the protrusion portion CP of the channel structure CH. The protrusion portion CP of the channel structure CH may be a portion including a channel expanded portion CHb (refer to FIG. 16) and/or a channel extending portion CHc (refer to FIG. 16) of the channel structure CH.

In the second etching process illustrated in FIG. 14, the opening 168p may be formed by removing another portion of the cover insulation layer 168a corresponding to another portion of the opening 168p in an extension direction of the channel structure CH or the thickness direction of the cover insulation layer 168a (the Z-axis direction in the drawing).. The opening 168p may be formed to expose the protrusion portion CP of the channel structure CH. By a wet etching process, a side surface of the cover insulation layer 168a in which the opening 168p is disposed may include a portion having a rounded shape or a concave shape. In this instance, the protrusion portion CP of the channel structure CH may include the gate dielectric layer 150 and the channel layer 140.

For example, the first etching process may be a dry etching process, and the second etching process may be a wet etching process. In a region where the protrusion portion CP is not disposed in the extension direction of the channel structure CH, the opening portion 168s may be formed by using the dry etching process. Thereby, the opening portion 168s may be formed at a desired position in a plan view, and time of the second etching process (e.g., the wet etching process) may be reduced. In a region where the protrusion portion CP is disposed in the extension direction of the channel structure CH, a portion of the cover insulation layer 168a under the opening portion 168s in a cross-sectional view may be stably removed by using the wet etching process to expose the channel structure CH. Thereby, a damage of the channel structure CH that may be induced in the dry etching process may be effectively prevented.

In an embodiment, by partially applying the first etching process and the second etching process different from each other, the opening 168p may be stably formed in the cover insulation layer 168a at a desired position in a plan view and in a cross-sectional view.

In an embodiment, a thickness of the portion of the cover insulation layer 168a removed by the first etching process may be greater than a thickness of the portion of the cover insulation layer 168a removed by the second etching process. Thereby, the opening 168p may be accurately formed at a desired position in a plan view, and process time of the second etching process (e.g., a wet etching process) may be reduced. However, the embodiments are not limited thereto. In an embodiment, the thickness of the portion of the cover insulation layer 168a removed by the first etching process may be same as or less than the thickness of the portion of the cover insulation layer 168a removed by the second etching process.

In an embodiment, the opening 168p may be formed in the cover insulation layer 168a by using the first etching process and the second etching process, and at least a portion of the cell array region 102 and another region may be stably physically or structurally separated without an additional structure.

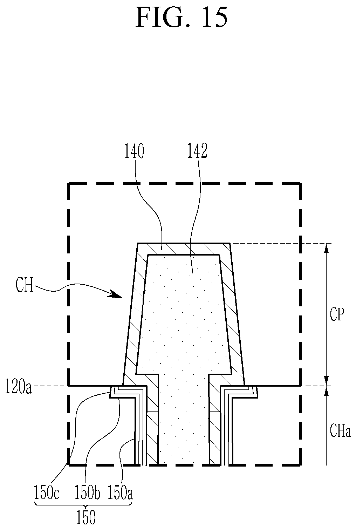

Subsequently, as illustrated in FIG. 15, a portion of the gate dielectric layer 150 in the protrusion portion CP of the channel structure CH may be removed. Thereby, the channel layer 140 of the channel structure CH may be exposed to an outside.

In an embodiment, the portion of the gate dielectric layer 150 in the protrusion portion CP of the channel structure CH exposed through the opening 168p of the cover insulation layer 168a may be removed. For example, a portion of a third dielectric portion 150c of the gate dielectric layer 150 at a first surface (an upper surface in FIG. 15) and a side surface of the protrusion portion CP of the channel structure CH may be removed. Thereby, a first dielectric portion 150a, a second dielectric portion 150b, and another portion of the third dielectric portion 150c of the gate dielectric layer 150 may remain. For example, a portion of the gate dielectric layer 150 may be removed such that a first surface (an upper surface in FIG. 15) of the gate dielectric layer 150 is on a same plane as the first surface 120a of the gate stacking structure 120. In the process of removing the portion of the gate dielectric layer 150, a portion of an outermost interlayer insulation layer 132n at the first surface 120a of the gate stacking structure 120 may be removed together. Even in this instance, the first surface of the gate dielectric layer 150 may be on a same plane as the first surface 120a of the gate stacking structure 120.

In an embodiment, in the process of removing the portion of the gate dielectric layer 150 to expose the channel layer 140 of the channel structure CH to an outside, the portion of the gate dielectric layer 150 at the protrusion portion CP of the channel structure CH may be removed. That is, a portion of the gate dielectric layer 150 in the channel penetration portion CHa of the channel structure CH may remain without removal. Thereby, the gate dielectric layer 150 may be disposed in the entirety of the channel penetration portion CHa having a relatively small width or area, and cutting, separation, a damage, a particle, or the like that may be induced or generated at the channel penetration portion CHa may be prevented. The gate dielectric layer 150 in the entirety of the side surface of the channel penetration portion CHa of the channel structure CH may physically or structurally support the channel structure CH, and the cutting, the separation, the damage, the particle, or the like that may be induced or generated at the channel penetration portion CHa may be prevented.

The process of removing the portion of the gate dielectric layer 150 may be performed by any of various processes (e.g., an etching process or the like).

Subsequently, as illustrated in FIG. 16, a portion of the channel layer 140 at least at a protrusion portion CP (refer to FIG. 15) of the channel structure CH may be removed. For example, a portion of the channel layer 140 at a first surface (an upper surface in FIG. 16), a side surface, a second surface (a lower surface in FIG. 16) of the protrusion portion CP of the channel structure CH, and a portion of the channel layer 140 at the side surface of the channel penetration portion CHa of the channel structure CH may be removed.

The process of removing the portion of the channel layer 140 may be performed by any of various processes (e.g., an etching process or the like). For example, in the process of removing the portion of the channel layer 140, a wet etching process may be performed within five minutes (e.g., within one minute).

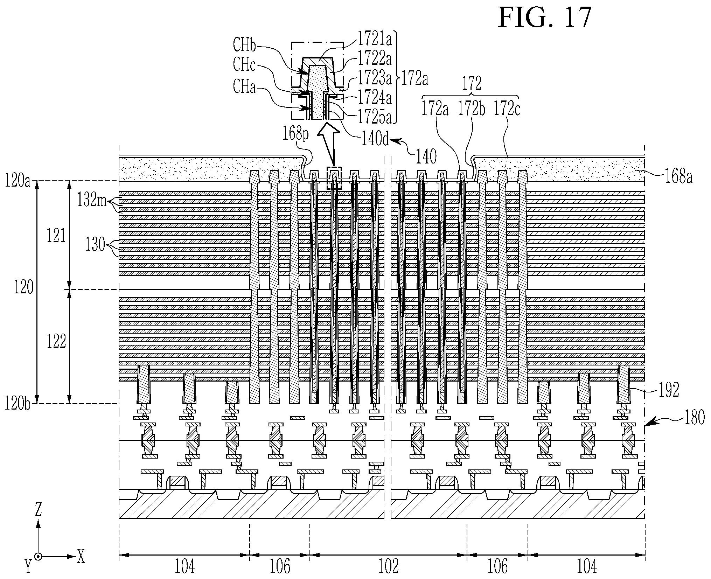

Subsequently, as illustrated in FIG. 17, a first common source layer 172 may be formed. The first common source layer 172 may be disposed on the first surface 120a of the gate stacking structure 120 and may be electrically connected to the channel structure CH. For example, after the first common source layer 172 is formed, a heat treatment may be performed.

In an embodiment, the first common source layer 172 may be formed on the first surface 120a of the gate stacking structure 120 and the channel structure CH exposed by the opening 168p. The first common source layer 172 may include a first portion 172a electrically connected to the channel structure CH. The first portion 172a may include a horizontal conductive portion 1721a, 1722a, and 1723a, and an extending conductive portion 1724a and 1725a. The horizontal conductive portion 1721a, 1722a, and 1723a may disposed on the first surface 120a of the gate stacking structure 120 and the channel structure CH. The extending conductive portion 1724a and 1725a may be disposed between the gate stacking structure 120 and the channel structure CH. The first common source layer 172 may further include a second portion 172b and/or a third portion 172c. The second portion 172b may be disposed on the side surface of the cover insulation layer 168a, and the third portion 172c may be disposed on an outer surface of the cover insulation layer 168a.

The extending conductive portion 1724a and 1725a may fill an empty space formed in the process of removing the portion of the channel layer 140. The extending conductive portion 1724a and 1725a may include a first extending portion 1724a and a second extending portion 1725a. The first extending portion 1724a may be disposed between a second surface (a lower surface in FIG. 17) of a channel expanded portion CHb and the second dielectric portion 150b. The second extending portion 1725a may be disposed on the first dielectric portion 150a at the side surface of the channel penetration portion CHa.

The first common source layer 172 may include or be formed of a doped semiconductor layer (e.g., an n-type or p-type polycrystalline silicon layer). However, the embodiments are not limited thereto.

The dopant included in the first common source layer 172 may be diffused to a portion of the channel layer 140 by the heat treatment, and a diffusion doping portion 140d may be formed in a portion of the channel layer 140 adjacent to the first common source layer 172.

The process of forming the first common source layer 172 may be performed by any of various processes (e.g., a deposition process or the like). The heat treatment process may be performed by any of various processes (e.g., a melting laser annealing (MLA) process or the like). However, the embodiments are not limited thereto.

The second extending portion 1725a and the diffusion doping portion 140d at the side surface of the channel penetration portion CHa and/or the channel extending portion CHc of the channel structure CH may be a sidewall doping region.

In an embodiment, the portion of the channel layer 140 may be removed and a common source layer 170 (e.g., the first common source layer 172) including a dopant may be directly formed in a portion where the channel layer 140 was removed. Thereby, instead of a process of doping a dopant into the channel layer 140 by using an ion implantation process, the common source layer 170 (e.g., the first common source layer 172) including the dopant may be formed. Therefore, the common source layer 170 (e.g., the first common source layer 172) including the dopant may be directly formed in a portion (e.g., a corner portion) that may have a high electrical resistance. Accordingly, in the portion that may have the high electrical resistance of, a cell current may be improved by a simple process.

A length or an area of the sidewall doping region that is at the side surface and has the dopant may be increased by the diffusion doping portion 140d formed by the diffusion of the dopant included in the first common source layer 172. Thereby, the cell current may be improved.

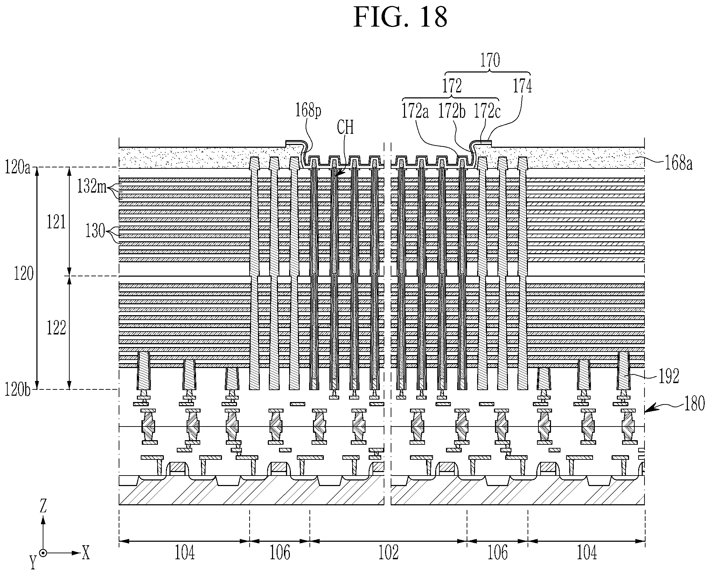

Subsequently, as illustrated in FIG. 18, a common source layer 170 may be formed by forming a second common source layer 174 on the first common source layer 172. In some embodiments, a patterning process of the common source layer 170 may be performed.

The second common source layer 174 may be formed by any of various processes (e.g., a deposition process or the like), and the patterning process of the common source layer 170 may be performed by any of various processes (e.g., an etching process or the like).

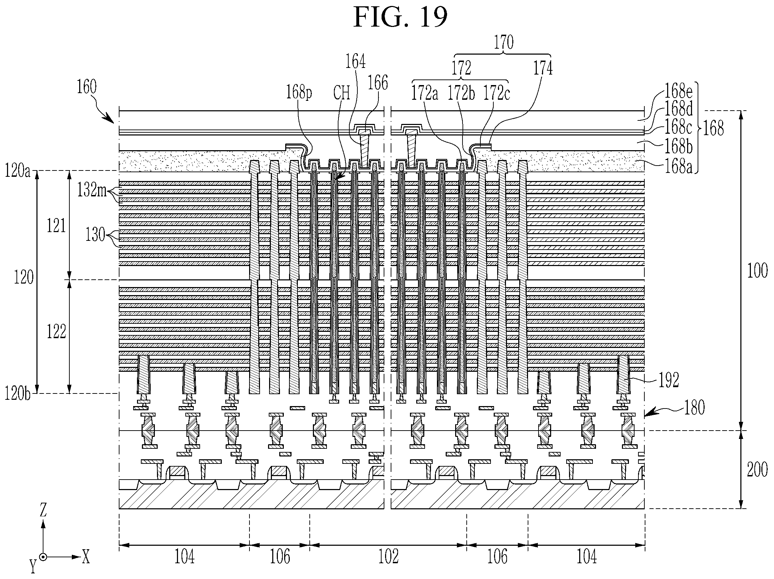

Subsequently, as illustrated in FIG. 19, a first wiring portion 160 other than the common source layer 170 may be formed. For example, a first insulation layer 168b may be formed on the common source layer 170, a first contact 164 and a pad 166 may be formed, a second insulation layer 168c, a third insulation layer 168d, and a fourth insulation layer 168e may be formed to form the first wiring portion 160.

According to an embodiment, the cover insulation layer 168a having the opening 168p may be included, and a structure selectively exposing at least a portion of the cell array region 102 may be formed by a simple manufacturing process. A portion of the gate dielectric layer 150 at the channel expanded portion CHb of the channel structure CH may be selectively removed, and a structural stability of the channel structure CH may be improved. The common source layer 170 may be formed in the empty space formed by removing the portion of the channel layer 140, and the cell current at a corner portion of the channel expanded portion CHb may be improved and a particle may be removed. That is, the semiconductor device having improved reliability may be easily formed by a simple process.

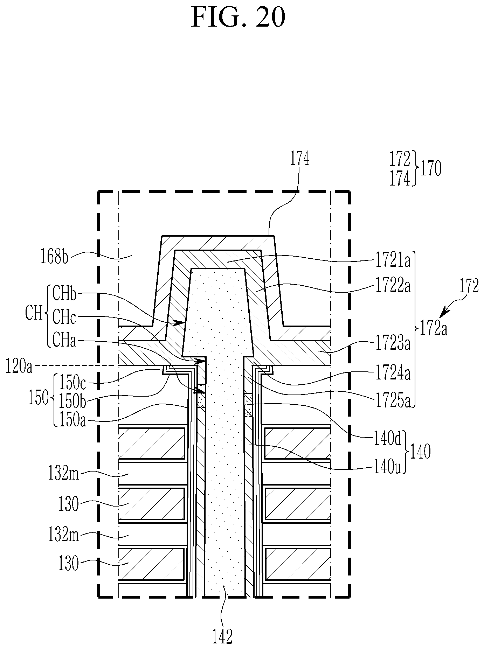

Hereinafter, referring to FIG. 20 to FIG. 27, semiconductor devices and manufacturing methods according to embodiments will be described in detail. To the extent that an element is not described in detail below, it may be understood that the element is at least similar to a corresponding element that has been described elsewhere within the present disclosure. A portion which is not described in the above will be described in detail.

FIG. 20 is a cross-sectional view illustrating a portion of a semiconductor device according to an embodiment. FIG. 20 illustrates a portion corresponding to FIG. 6.

Referring to FIG. 20, in an embodiment, in an extension direction of a channel structure CH, a common source layer 172 may include portions having a difference in length of a second extending portion 1725, or a channel layer 140 may include portions having a difference in position of a diffusion doping portions 140d. That is, in an embodiment, in the extension direction of the channel structure CH, a sidewall doping region (e.g., the second extending portion 1725a and/or the diffusion doping portion 140d) may include portions having a difference in length or position.

For example, when a channel penetration portion CHa is not disposed at a center of a channel expanded portion CHb and thus has an asymmetrical structure when viewed in a cross-sectional view, there may be a difference in removed length of a channel layer 140 in a process of removing a portion of the channel layer 140 adjacent to the channel expanded portion CHb. For example, the channel layer 140 may be relatively more removed in a portion closer to an edge of the channel expanded portion CHb, and the channel layer 140 may be relatively less removed in a portion far away from the edge of the channel expanded portion CHb.

Thereby, in the extension direction of the channel structure CH, the first common source layer 172 may include portions having a different in length of the second extending portion 1725a. When a heat treatment is performed after the first common source layer 172 is formed, the first common source layer 172 may include portions having a difference in position of an end of the first common source layer 172 where a diffusion of a dopant begins, and thus, the channel layer 140 may include portions having a difference in position of the diffusion doping portion 140d.

FIG. 21 is a cross-sectional view illustrating a portion of a semiconductor device according to an embodiment. FIG. 21 illustrates a portion corresponding to FIG. 6.

Referring to FIG. 21, in an embodiment, in an extension direction of a channel structure CH, a first surface 120a of a gate stacking structure 120 may be highly disposed than a first surface 150h (an upper surface in FIG. 21) of a second dielectric portion 150b of a gate dielectric layer 150. For example, in the extension direction of the channel structure CH, the first surface 120a of the gate stacking structure 120 may be disposed between a first surface (an upper surface in FIG. 21) and a second surface (a lower surface in FIG. 21) of a channel expanded portion CHb.

In the extension direction of the channel structure CH, a third dielectric portion 150c may include a portion extending in a direction parallel to a side surface of the channel expanded portion CHb such that the third dielectric portion 150c includes a portion overlapping a side surface of the channel expanded portion CHb. For example, the first surface 120a of the gate stacking structure 120 may be on a same plan as a first surface (an upper surface in FIG. 21) of the third dielectric portion 150c of the gate dielectric layer 150. The third dielectric portion 150c may include the portion overlapping the side surface of the channel expanded portion CHb, and may stably surround the entirety of the channel penetration portion CHa and the channel extending portion CHc.

An extending conductive portion 1724a, 1725a, and 1726a of a first common source layer 172 may include a first extending portion 1724a, a second extending portion 1725a, and a third extending portion 1726a. The third extending portion 1726a may be disposed between the channel expanded portion CHb (e.g., a core insulation layer 142 in the channel expanded portion CHb) and the third dielectric portion 150c. The third extending portion 1726a may extend in a direction parallel to the second horizontal portion 1722a and may connect the first extending portion 1724a and a second and/or third horizontal portion 1722a and/or 1723a. In a cross-sectional view, the third extending portion 1726a may have an obtuse angle (e.g., an angle greater than 90 degrees and less than 180 degrees) with each of the first extending portion 1724a and the third horizontal portion 1723a.

A thickness of the third extending portion 1726a may be substantially same as a thickness of the first extending portion 1724a, a thickness of the second extending portion 1725a, or a thickness of a channel layer 140. For example, the thickness of the third extending portion 1726a may be in a range of 90% to 110% of the thickness of the first extending portion 1724a, the thickness of the second extending portion 1725a, or the thickness of the channel layer 140. A description of the thickness T4 of the first extending portion 1724a and/or the thickness T5 of the second extending portion 1725a with reference to FIG. 6 may be applied to the thickness of the third extending portion 1726a.

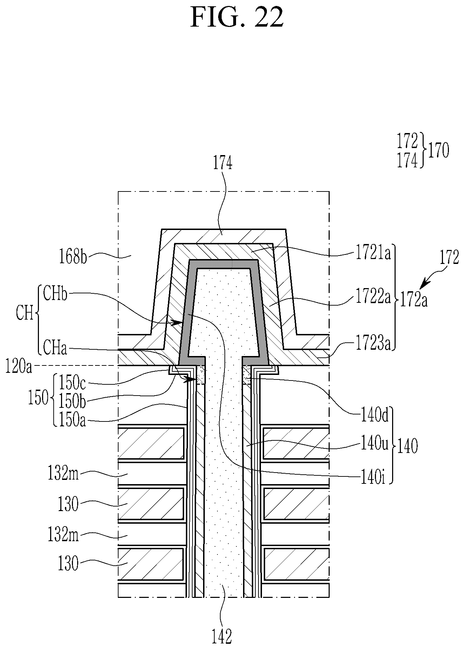

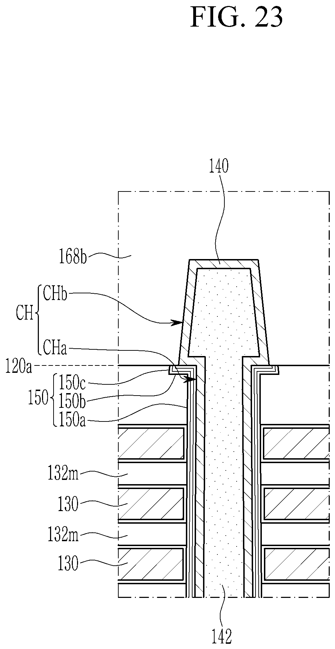

FIG. 22 is a cross-sectional view illustrating a portion of a semiconductor device according to an embodiment. FIG. 23 to FIG. 26 are cross-sectional views illustrating a manufacturing method of the semiconductor device illustrated in FIG. 22. FIG. 22 to FIG. 26 illustrate a portion corresponding to FIG. 6.

Referring to FIG. 22, in an embodiment, a channel structure CH may include a channel penetration portion CHa and a channel expanded portion CHb.

The channel penetration portion CHa may extend to pass through a gate stacking structure 120. The channel expanded portion CHb may be on a first surface 120a of the gate stacking structure 120 and may have a width or an area greater than a width or an area of the channel penetration portion CHa. The channel penetration portion CHa may be disposed in the gate stacking structure 120, and may include a gate dielectric layer 150, a channel layer 140, and a core insulation layer 142. The channel expanded portion CHb may be disposed on the first surface 120a of the gate stacking structure 120, and may include the channel layer 140 and the core insulation layer 142 without the gate dielectric layer 150.

In an embodiment, the channel layer 140 may be disposed in the channel expanded portion CHb. For example, in the channel expanded portion CHb, the channel layer 140 may be disposed on a first surface (an upper surface in FIG. 22), a side surface, and a second surface (a lower surface in FIG. 22) of the core insulation layer 142. A portion corresponding to a channel extending portion CHc (refer to FIG. 6) may not be included.

In an embodiment, the channel layer 140 may include a high concentration doping portion 140i, a diffusion doping portion 140d, and an undoped portion 140u. The high concentration doping portion 140i may be disposed on a first surface, a side surface, and a second surface of the core insulation layer 142 in the channel expanded portion CHb. The diffusion doping portion 140d may be disposed in a portion adjacent to the high concentration doping portion 140i at a side surface of a portion of the channel penetration portion CHa. The undoped portion 140u may be disposed in a portion other than the diffusion doping portion 140d at a side surface of another portion of the channel penetration portion CHa.

The high concentration doping portion 140i may be a region formed by doping a dopant to a portion of the channel layer 140 in the channel expanded portion CHb, and the diffusion doping portion 140d may be formed by a diffusion of the dopant included in the high concentration doping portion 140i to a portion of the channel layer 140.

The high concentration doping portion 140i may have a doping concentration higher than a doping concentration of the diffusion doping portion 140d and the undoped portion 140u. The high concentration doping portion 140i may have a substantially same or uniform doping concentration. For example, a first portion 172a of a first common source layer 172 (e.g., a horizontal conductive portion 1721a, 1722a, and 1723a), a second portion, and a third portion may have a substantially same or uniform doping concentration. The diffusion doping portion 140d may have a doping concentration higher than a doping concentration of the undoped portion 140u, and the doping concentration of the diffusion doping portion 140d may gradually decrease far away from the high concentration doping portion 140i.

By the doping concentration, positions of the high concentration doping portion 140i and the diffusion doping portion 140d, and a boundary of the high concentration doping portion 140i and the diffusion doping portion 140d may be confirmed or expected.

In an embodiment, in the channel structure CH including the channel expanded portion CHb, a horizontal doping region at the second surface (the lower surface in FIG. 22) of the channel expanded portion CHb and a sidewall doping region adjacent to a side surface of the channel penetration portion CHa may be included. For example, the horizontal doping region may include at least a portion of the high concentration doping portion 140i, and the sidewall doping region may include the diffusion doping portion 140d of the channel layer 140.

In an embodiment, the first portion 172a of the first common source layer 172 may include a horizontal conductive portion 1721a, 1722a, and 1723a. The horizontal conductive portion 1721a, 1722a, and 1723a may include a first horizontal portion 1721a, a second horizontal portion 1722a, and a third horizontal portion 1723a. The first horizontal portion 1721a may be disposed on the first surface (the upper surface in FIG. 22) of the channel expanded portion CHb. The second horizontal portion 1722a may be disposed on the side surface of the channel expanded portion CHb. The third horizontal portion 1723a may be disposed at a periphery of the channel expanded portion CHb on the first surface 120a of the gate stacking structure 120. A portion corresponding to a extending conductive portion 1724a and 1725a in FIG. 6 may not be included.

The first horizontal portion 1721a and the second horizontal portion 1722a may be disposed on the channel layer 140 (e.g., the high concentration doping portion 140i). For example, the first horizontal portion 1721a and the second horizontal portion 1722a may be in contact with the channel layer 140 (e.g., the high concentration doping portion 140i). However, the embodiments are not limited thereto.

A doping concentration of the high concentration doping portion 140i may be less than a doping concentration of the first common source layer 172. However, the embodiments are not limited thereto.

A manufacturing method of the semiconductor device will be described with reference to FIG. 23 to FIG. 26. To the extent that an element is not described in detail below, it may be understood that the element is at least similar to a corresponding element that has been described elsewhere within the present disclosure. A portion which is not described in the above will be described in detail.

As illustrated in FIG. 23, a preliminary cell region may be bonded to a circuit region, a semiconductor substrate may be removed, a cover insulation layer having an opening may be formed, and a portion of a gate dielectric layer 150 in a protrusion portion of a channel structure CH may be removed. A description with reference to FIG. 8 to FIG. 15 may be applied thereto.

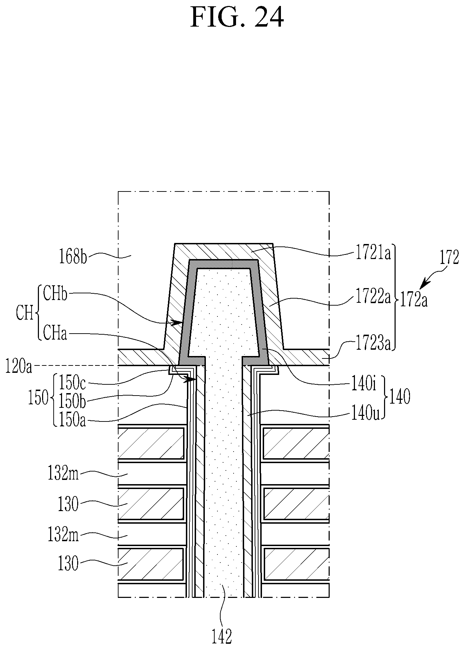

Subsequently, as illustrated in FIG. 24, a high concentration doping portion 140i may be formed in a channel layer 140, and a first common source layer 172 may be formed. The first common source layer 172 may be formed on a first surface 120a of a gate stacking structure 120 and may be electrically connected to the channel structure CH.

The process of forming the high concentration doping portion 140i in the channel layer 140 may be performed by any of various doping processes (e.g., an ion implantation process or the like) of doping a dopant (e.g., an n-type or p-type dopant). The process of forming the first common source layer 172 may be performed by any of various processes (e.g., a deposition process or the like). The first common source layer 172 may include a doped semiconductor layer (e.g., n-type or p-type polycrystalline silicon layer). However, the embodiments are not limited thereto.

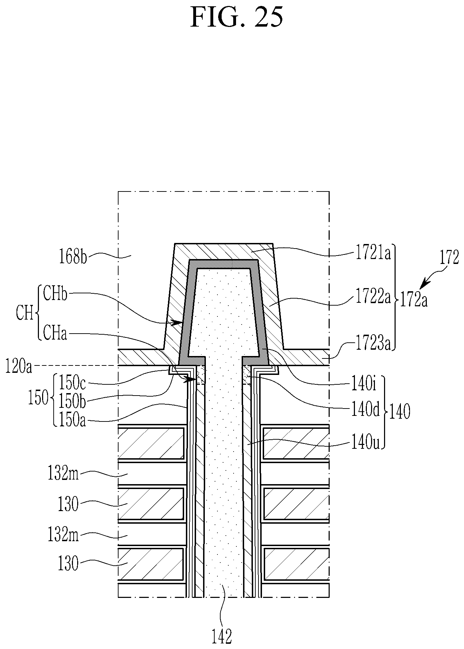

Subsequently, as illustrated in FIG. 25, a diffusion doping portion 140d may be formed in a portion of the channel layer 140 adjacent to the high concentration doping portion 140i by performing a heat treatment process. The heat treatment process may be performed by any of various processes (e.g., a fusion laser annealing process or the like). However, the embodiments are not limited thereto.

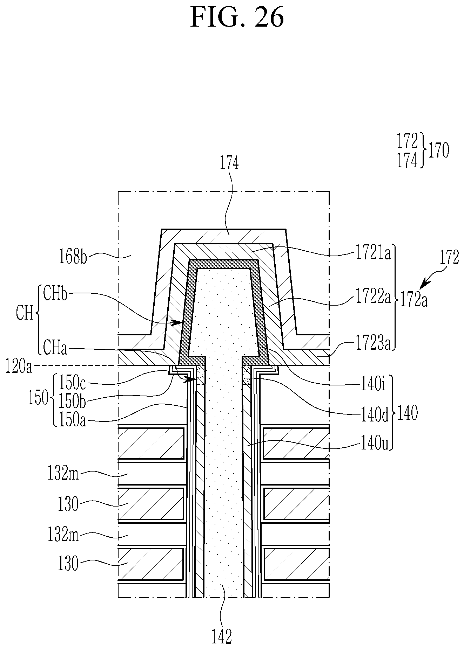

Subsequently, as illustrated in FIG. 26, a common source layer 170 may be formed by forming a second common source layer 174 on the first common source layer 172. A description with reference to FIG. 18 may be applied to the process of forming the common source layer 170. A first wiring portion other than the common source layer 170 may be formed. A description with reference to FIG. 19 may be applied to the process of forming the first wiring portion.

According to an embodiment, by forming the high concentration doping portion 140i through doping the portion of the channel layer 140 without the process of removing the portion of the channel layer 140, a horizontal doping region and a sidewall doping region may be formed in the channel structure CH including the channel expanded portion CHb. Accordingly, a cell current at a corner portion of the channel expanded portion CHb may be improved.

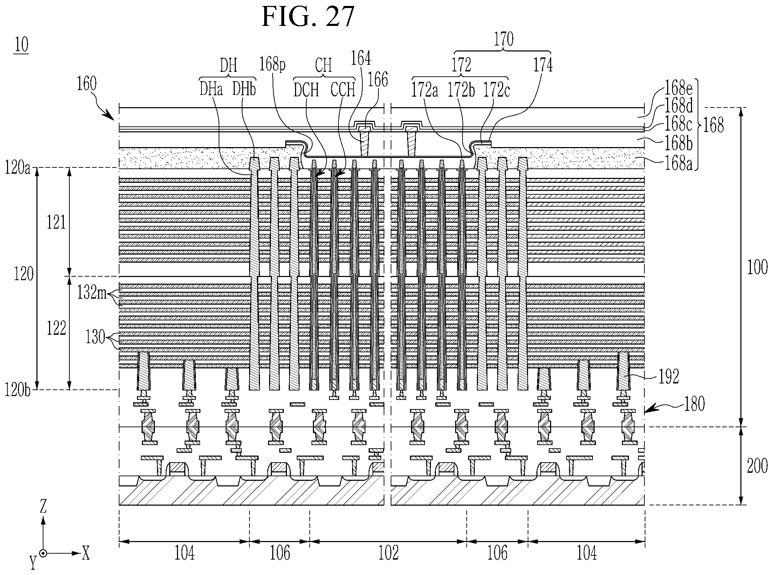

FIG. 27 is a partial cross-sectional view schematically illustrating a semiconductor device according to an embodiment. FIG. 27 illustrates a portion corresponding to FIG. 5.

Referring to FIG. 27, in an embodiment, in a first common source layer 172, a first surface (an upper surface in FIG. 27) of a first horizontal portion, a first surface (an upper surface in FIG. 27) of a second horizontal portion, and a first surface (an upper surface in FIG. 27) of a third horizontal portion may be disposed on a same plane. In an extension direction of a channel structure CH (a Z-axis direction in the drawings), a thickness of the first common source layer 172 (e.g., the third horizontal portion) may be greater than a height of a channel expanded portion CHb, and a first surface (an upper surface in FIG. 27) of the first common source layer 172 may be disposed outside the channel expanded portion CHb. For example, the first surface (the upper surface in FIG. 27) of a first portion 172a of the first common source layer 172 may be a substantially flat surface, and a second surface (a lower surface in FIG. 27) of the first portion 172a of the first common source layer 172 may have a bent portion or a step portion.

A first portion of the second common source layer 174 on the first portion 172a of the first common source layer 172 may have a planar shape extending in a horizontal direction. Each of a first surface (an upper surface in FIG. 27) and a second surface (a lower surface in FIG. 27) of the first portion of the second common source layer 174 on the first portion 172a of the first common source layer 172 may be a flat surface.

For example, when the first common source layer 172 may include or be formed of a material being changed or melted in a heat treatment process performed after forming the first common source layer 172, the first common source layer 172 may have the above shape. In some embodiments, the first common source layer 172 may have a relatively large thickness, and the first common source layer 172 having the above shape may be formed.

An example of an electronic system including a semiconductor device will be described in detail below.

FIG. 28 schematically illustrates an electronic system including a semiconductor device according to an embodiment.

Referring to FIG. 28, an electronic system 1000 according to an embodiment may include a semiconductor device 1100 and a controller 1200 that is electrically connected to the semiconductor device 1100. The electronic system 1000 may be a storage device that includes one or a plurality of semiconductor devices 1100 or an electronic device that includes the storage device. For example, the electronic system 1000 may be a solid-state drive (SSD) device, a universal serial bus (USB), a computing system, a medical device, or a communication device that includes one or a plurality of semiconductor devices 1100.

The semiconductor device 1100 may be a non-volatile memory device/ For example, the semiconductor device 1100 may be a NAND flash memory device described with reference to FIG. 1 to FIG. 27. The semiconductor device 1100 may include a first structure 1100F and a second structure 1100S that is disposed on the first structure 1100F. The first structure 1100F may be a peripheral circuit structure that includes a decoder circuit 1110, a page buffer 1120, and a logic circuit 1130. The second structure 1100S may be a memory cell structure that includes a bit line BL, a common source line CSL, a word line WL, first and second gate upper lines UL1 and UL2, first and second gate lower lines LL1 and LL2, and a memory cell string CSTR between the bit line BL and the common source line CSL.

In the second structure 1100S, each of memory cell strings CSTR may include lower transistors LT1 and LT2 that are adjacent to the common source line CSL, upper transistors UT1 and UT2 that are adjacent to the bit line BL, and a plurality of memory cell transistors MCT between the lower transistors LT1 and LT2 and the upper transistors UT1 and UT2. A number of the lower transistors LT1 and LT2 and a number of the upper transistors UT1 and UT2 may be variously modified according to an embodiment.

In an embodiment, the lower transistor LT1 or LT2 may include a ground selection transistor, and the upper transistor UT1 or UT2 may include a string selection transistor. The first and second gate lower lines LL1 and LL2 may be gate electrodes of the lower transistors LT1 and LT2, respectively. The word line WL may be a gate electrode of the memory cell transistor MCT, and the gate upper lines UL1 and UL2 may be gate electrodes of the upper transistors UT1 and UT2, respectively.

The common source line CSL, the first and second gate lower lines LL1 and LL2, the word line WL, and the first and second gate upper lines UL1 and UL2 may be electrically connected to the decoder circuit 1110 through a first connection wiring 1115 that extends to the second structure 1100S within the first structure 1100F. The bit line BL may be electrically connected to the page buffer 1120 through a second connection wiring 1125 that extends to the second structure 1100S within the first structure 1100F.

In the first structure 1100F, the decoder circuit 1110 and the page buffer 1120 may execute a control operation for at least one memory cell transistor selected from the plurality of memory cell transistors MCT. The decoder circuit 1110 and the page buffer 1120 may be controlled by the logic circuit 1130. The semiconductor device 1100 may communicate with the controller 1200 through an input/output pad 1101 that is electrically connected to the logic circuit 1130. The input/output pad 1101 may be electrically connected to the logic circuit 1130 through an input/output connection wiring 1135 that extends to the second structure 1100S within the first structure 1100F.

The controller 1200 may include a processor 1210, a NAND controller 1220, and a host interface 1230. In some embodiments, the electronic system 1000 may include a plurality of semiconductor devices 1100, and in this case, the controller 1200 may control the plurality of semiconductor devices 1100.

The processor 1210 may control an overall operation of the electronic system 1000 including the controller 1200. The processor 1210 may operate according to predetermined firmware, and may access the semiconductor device 1100 by controlling the NAND controller 1220. The NAND controller 1220 may include a NAND interface 1221 that processes communication with the semiconductor device 1100. A control command for controlling the semiconductor device 1100, data to be written in the memory cell transistor MCT of the semiconductor device 1100, and data to be read from the memory cell transistor MCT of the semiconductor device 1100, or the like may be transmitted through the NAND interface 1221. The host interface 1230 may provide a communication function between the electronic system 1000 and an external host. When a control command is received from the external host through the host interface 1230, the processor 1210 may control the semiconductor device 1100 in response to the control command.

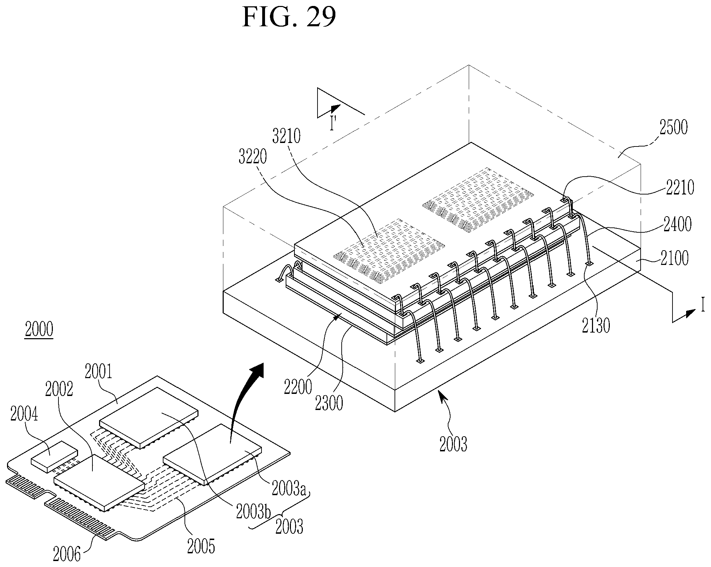

FIG. 29 is a perspective view schematically illustrating an electronic system including a semiconductor device according to an embodiment.

Referring to FIG. 29, an electronic system 2000 according to an embodiment may include a main substrate 2001, a controller 2002 that is mounted on the main substrate 2001, one or more semiconductor packages 2003, and a DRAM 2004. The semiconductor package 2003 and the DRAM 2004 may be connected to the controller 2002 through a wiring pattern 2005 that is provided on the main substrate 2001.

The main substrate 2001 may include a connector 2006 that includes a plurality of pins coupled to the external host. A number and an arrangement of the plurality of pins in the connector 2006 may vary depending on a communication interface between the electronic system 2000 and the external host. In an embodiment, the electronic system 2000 may communicate with the external host according to any one of interfaces such as a universal serial bus (USB), a peripheral component interconnect express (PCI-Express), a serial advanced technology attachment (SATA), or an M-Phy for a universal flash storage (UFS). In an embodiment, the electronic system 2000 may operate by power that is supplied from the external host through the connector 2006. The electronic system 2000 may further include a power management integrated circuit (PMIC) that distributes the power supplied from the external host to the controller 2002 and the semiconductor package 2003.

The controller 2002 may write data in the semiconductor package 2003 or may read data from the semiconductor package 2003, and may improve an operating speed of the electronic system 2000.

The DRAM 2004 may be a buffer memory for mitigating or buffering a speed difference between the semiconductor package 2003, which is a data storage space, and the external host. The DRAM 2004 that is included in the electronic system 2000 may also be a kind of cache memory, and may also provide a space for temporarily storing data in a control operation for the semiconductor package 2003. When the electronic system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b that are spaced apart from each other. Each of the first and second semiconductor packages 2003a and 2003b may be a semiconductor package that includes a plurality of semiconductor chips 2200. Each of the first and second semiconductor packages 2003a and 2003b may include a package substrate 2100, a semiconductor chip 2200 that is disposed on the package substrate 2100, an adhesive layer 2300 at a lower surface of each semiconductor chip 2200, a connection structure 2400 that electrically connects the semiconductor chip 2200 and the package substrate 2100, and a molding layer 2500 that covers the semiconductor chip 2200 and the connection structure 2400 on the package substrate 2100.

The package substrate 2100 may be a printed circuit board that includes a package upper pad 2130. Each semiconductor chip 2200 may include an input/output pad 2210. The input/output pad 2210 may correspond to an input/output pad 1101 of FIG. 28. Each semiconductor chip 2200 may include a gate stacking structure 3210 and a channel structure 3220. The semiconductor chip 2200 may include a semiconductor device described with reference to FIG. 1 to FIG. 27.

In an embodiment, the connection structure 2400 may be a bonding wire that electrically connects the input/output pad 2210 and the package upper pad 2130. Accordingly, in each of the first and second semiconductor packages 2003a and 2003b, the semiconductor chips 2200 may be electrically connected to each other using a bonding wire type, and the semiconductor chip 2200 may be electrically connected to the package upper pad 2130 of the package substrate 2100 using a bonding wire type. In some embodiments, in each of the first and second semiconductor packages 2003a and 2003b, the semiconductor chips 2200 may be electrically connected to each other by a connection structure that includes a through silicon via (TSV) instead of the connection structure 2400 of the bonding wire type.

In an embodiment, the controller 2002 and the semiconductor chip 2200 may be included in one package. For example, the controller 2002 and the semiconductor chip 2200 may be mounted on a separate interposer substrate that is different from the main substrate 2001, and the controller 2002 and the semiconductor chip 2200 may be connected to each other by a wiring of the interposer substrate.

FIG. 30 is a cross-sectional view schematically illustrating a semiconductor package according to an embodiments. FIG. 30 illustrates an embodiment of the semiconductor package 2003 in FIG. 29, and conceptually illustrates a region obtained by cutting the semiconductor package 2003 in FIG. 29 along a line I-I'.

Referring to FIG. 30, in a semiconductor package 2003, the package substrate 2100 may be a printed circuit board. The package substrate 2100 may include a package substrate body portion 2120, a package upper pad 2130 at an upper surface of the package substrate body portion 2120, a package lower pad 2125 disposed at a lower surface of the package substrate body portion 2120 or exposed through the lower surface of the package substrate body portion 2120, and an internal wiring 2135 electrically connecting the package upper pad 2130 and the package lower pad 2125 inside the package substrate body portion 2120. The package upper pad 2130 may be electrically connected to the connection structure 2400. The package lower pad 2125 may be connected to a wiring pattern 2005 of the main substrate 2001 of the electronic system 2000 illustrated in FIG. 29 through a conductive connection portion 2800.

In a semiconductor package 2003A, each semiconductor chip 2200a may include a semiconductor substrate 4010, a first structure 4100 on the semiconductor substrate 4010, and a second structure 4200 disposed on the first structure 4100 and bonded to the first structure 4100 by a wafer bonding type.

The first structure 4100 may include a peripheral circuit region including a peripheral wiring 4110 and a first bonding structure 4150. The second structure 4200 may include a common source line 4205, a gate stacking structure 4210 between the common source line 4205 and the first structure 4100, a channel structure 4220 and a separation structure 4230 penetrating the gate stacking structure 4210, and a second bonding structure 4250 electrically connected to the channel structure 4220 and a word line WL (refer to FIG. 28) of the gate stacking structure 4210. For example, the second bonding structure 4250 may be electrically connected to the channel structure 4220 and the word line WL through a bit line 4240 electrically connected to the channel structure 4220 and a gate connection wiring electrically connected to the word line WL. The first bonding structure 4150 of the first structure 4100 and the second bonding structure 4250 of the second structure 4200 may be in contact with and bonded to each other. For example, portions of the first bonding structure 4150 and the second bonding structure 4250 where the first bonding structure 4150 and the second bonding structure 4250 are bonded may include copper (Cu).

In an embodiment, a cover insulation layer having an opening may be included, the entirety of a side surface of a channel penetration portion may be surrounded by a gate dielectric layer, and a common source layer may be formed in an empty space formed by removing a portion of a channel layer and thus a cell current may be improved. Thereby, productivity and reliability of the semiconductor device may be improved.

Each of the semiconductor chips 2200 may further include an input/output pad 2210 and an input/output connection wiring 4265 at a lower portion of the input/output pad 2210. The input/output connection wiring 4265 may be electrically connected to a part of the second bonding structures 4250.

In an embodiment, in the semiconductor package 2003, a plurality of semiconductor chips 2200 may be electrically connected to each other by the connection structure 2400 having a bonding wire type. In some embodiments, the plurality of semiconductor chips 2200 or a plurality of portions constituting the plurality of semiconductor chips 2200 may be electrically connected by a connection structure including a through silicon via (TSV).

While some examples have been described in connection with what is presently considered to be some practical embodiments, it is to be understood that the disclosure is not limited to the disclosed embodiments, and that the disclosure is intended to cover various modifications and equivalent arrangements included within the spirit and scope of the appended claims.

## Claims

1. A semiconductor device including a cell array region (102) and a connection region (104), the semiconductor device comprising:
a gate stacking structure (120) having a first surface (120a) and a second surface (120b) opposite to each other, wherein the gate stacking structure (120) includes a plurality of interlayer insulation layers (132m) and a plurality of gate electrodes (130) alternately stacked on each other;
a channel structure (CH) including a channel penetration portion (CHa) and a channel expanded portion (CHb), wherein the channel penetration portion (CHa) extends to pass through the gate stacking structure (120), and the channel expanded portion (CHb) is on the first surface (120a) of the gate stacking structure (120) and has a width or an area greater than a width or an area of the channel penetration portion (CHa);
a cover insulation layer (168a) on the first surface (120a) of the gate stacking structure (120), covering the connection region (104) and having an opening (168p) exposing at least a portion of the cell array region (102); and
a common source layer (170) including a horizontal conductive portion (1721a, 1722a, 1723a) on the first surface (120a) of the gate stacking structure (120) and the channel expanded portion (CHb) exposed by the opening (168p),
wherein the channel structure (CH) includes a channel layer (140) and a gate dielectric layer (150), and
wherein the gate dielectric layer (150) includes a first dielectric portion (150a) in the channel penetration portion (CHa) and a second dielectric portion (150b) extending from the first dielectric portion (150a) in a horizontal direction at a portion adjacent to the first surface (120a) of the gate stacking structure (120).

2. The semiconductor device of claim 1, wherein the gate dielectric layer (150) further includes a third dielectric portion (150c) extending from the second dielectric portion (150b) to be parallel to a side surface of the channel expanded portion (CHb).

3. The semiconductor device of claim 1 or 2, wherein the common source layer (170) includes an extending conductive portion (1724a, 1725a, 1726a) including a portion between the gate stacking structure (120) and at least a portion of the channel structure (CH).

4. The semiconductor device of claim 3, wherein a thickness of the extending conductive portion (1724a, 1725a, 1726a) is substantially the same as a thickness of the channel layer (140).

5. The semiconductor device of claim 3 or 4, wherein a thickness of the extending conductive portion (1724a, 1725a, 1726a) is less than a thickness of the horizontal conductive portion (1721a, 1722a, 1723a).

6. The semiconductor device of any one of claims 1 to 5, wherein the common source layer (170) includes a first extending portion (1724a) and a second extending portion (1725a),
wherein the first extending portion (1724a) is between a surface of the channel expanded portion (CHb) adjacent to the first surface (120a) of the gate stacking structure (120) and the second dielectric portion (150b), and
wherein the second extending portion (1725a) extends from the first extending portion (1724a) and is on the first dielectric portion (150a) at a side surface of the channel penetration portion (CHa).

7. The semiconductor device of claim 6, wherein, in an extension direction of the channel structure (CH), the second extending portion (1725a) does not overlap the plurality of gate electrodes (130) or overlaps one or two gate electrodes of the plurality of gate electrodes (130).

8. The semiconductor device of claim 6 or 7, wherein, in an extension direction of the channel structure (CH), the second extending portion (1725a) is inside an outermost interlayer insulation layer (132n) of the plurality of interlayer insulation layers (132m) that is at the first surface (120a) of the gate stacking structure (120).

9. The semiconductor device of any one of claims 1 to 8, comprising:
a horizontal doping region between the second dielectric portion (150b) and the channel expanded portion (CHb); and
a sidewall doping region on the first dielectric portion (150a) at a side surface of the channel structure (CH) or the gate stacking structure (120).

10. The semiconductor device of claim 9, wherein the horizontal doping region is or includes a portion of the common source layer (170).

11. The semiconductor device of claim 9 or 10, wherein the channel structure (CH) further includes a core insulation layer (142) in the channel layer (140), and
wherein the sidewall doping region includes an extending conductive portion of the common source layer (170) between the first dielectric portion (150a) and the core insulation layer and a diffusion doping portion of the channel layer (140) adjacent to the common source layer (170).

12. The semiconductor device of any one of claims 9 to 11, wherein, in an extension direction of the channel structure (CH), a length of the sidewall doping region is greater than a thickness of the horizontal doping region.

13. The semiconductor device of any one of claims 9 to 12, wherein the sidewall doping region includes
portions having a difference in length or position in an extension direction of the channel structure (CH).

14. The semiconductor device of any one of claims 1 to 13, wherein the common source layer (170) surrounds a surface of the channel expanded portion (CHb).

15. The semiconductor device of any one of claims 1 to 14, wherein a side surface of the cover insulation layer (168a) in which the opening (168p) is disposed includes a portion having a concave shape.
